(19) Europäisches Patentamt
European Patent Office
Office européen des brevets

(11) EP 3 857 621 B1

(12) **EUROPÄISCHE PATENTSCHRIFT**

(45) Veröffentlichungstag und Bekanntmachung des Hinweises auf die Patenterteilung:
**29.10.2025 Patentblatt 2025/44**

(21) Anmeldenummer: **19769818.6**

(22) Anmeldetag: **23.09.2019**

(51) Internationale Patentklassifikation (IPC):
***B01J 2/04*** *(2006.01)* ***H10K 71/16*** *(2023.01)*

(52) Gemeinsame Patentklassifikation (CPC):
**H10K 71/16;** B01J 2/04

(86) Internationale Anmeldenummer:
**PCT/EP2019/075445**

(87) Internationale Veröffentlichungsnummer:
**WO 2020/064582 (02.04.2020 Gazette 2020/14)**

# (54) VERFAHREN ZUR HERSTELLUNG VON GRANULAT

METHOD FOR THE PRODUCTION OF A GRANULAR MATERIAL

PROCÉDÉ DE PRODUCTION DE GRANULAT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.09.2018 EP 18196249**

(43) Veröffentlichungstag der Anmeldung:
**04.08.2021 Patentblatt 2021/31**

(73) Patentinhaber: **Merck Patent GmbH**
**64293 Darmstadt (DE)**

(72) Erfinder:
- **KAUFHOLD, Oliver**
  **64297 DARMSTADT (DE)**
- **COERS, Larry**
  **Urbana, IL 61802 (US)**
- **TAYLOR, Samuel**
  **Mahomet, IL 61853 (US)**

(74) Vertreter: **Merck Patent Association**
**Merck Patent GmbH**
**64271 Darmstadt (DE)**

(56) Entgegenhaltungen:
**EP-A1- 2 014 355** **DE-A1- 1 767 615**
**DE-C- 236 477** **US-A- 4 400 191**
**US-A1- 2008 268 245**

- **RAMAKRISHNA BHEERAPPAGARI ET AL: "Reversible Fluorescence Modulation in a Dyad Comprising Phenothiazine Derivative and Spiropyran", ASIAN JOURNAL OF ORGANIC CHEMISTRY , 1(2), 160-165 CODEN: AJOCC7; ISSN: 2193-5807, vol. 7, no. 11, 14 August 2018 (2018-08-14), Germany, pages 2254 - 2262, XP093214240, ISSN: 2193-5807, DOI: 10.1002/ajoc.201800338**
- **ZHANGXIAN CHEN ET AL: "Fabrication of Highly Transparent and Conductive Indium-Tin Oxide Thin Films with a High Figure of Merit via Solution Processing", LANGMUIR, vol. 29, no. 45, 28 October 2013 (2013-10-28), US, pages 13836 - 13842, XP055642546, ISSN: 0743-7463, DOI: 10.1021/la4033282**
- **PENG HU ET AL: "Single-crystal growth, structures, charge transfer and transport properties of anthracene-F 4 TCNQ and tetracene-F 4 TCNQ charge-transfer compounds", CRYSTENGCOMM, vol. 19, no. 4, 1 January 2017 (2017-01-01), pages 618 - 624, XP055643111, DOI: 10.1039/C6CE02116F**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 857 621 B1

## Beschreibung

Die vorliegende Erfindung beschreibt ein Verfahren zur Herstellung von Granulat, enthaltend mindestens ein funktionales Material (FM), welches zur Herstellung von Funktionsschichten elektronischer Vorrichtungen einsetzbar ist. Die Erfindung betrifft ferner ein Granulat erhältlich gemäß dem vorliegenden Verfahren sowie die Verwendung desselben zur Herstellung einer elektronischen Vorrichtung.

Elektronische Vorrichtungen, welche organische, metallorganische und/oder polymere Halbleiter enthalten, gewinnen zunehmend an Bedeutung, wobei diese aus Kostengründen und aufgrund ihrer Leistungsfähigkeit in vielen kommerziellen Produkten eingesetzt werden. Als Beispiele seien hier Ladungstransportmaterialien auf organischer Basis (z.B. Lochtransporter auf Triarylamin-Basis) in Kopiergeräten, organischen oder polymeren Leuchtdioden (OLEDs oder PLEDs) und in Anzeige- und Displayvorrichtungen oder organische Photorezeptoren in Kopierern genannt. Organische Solarzellen (O-SC), organische FeldeffektTransistoren (O-FET), organische Dünnfilm-Transistoren (O-TFT), organische Schaltelemente (O-IC), organische optische Verstärker und organische Laserdioden (O-Laser) sind in einem fortgeschrittenen Entwicklungsstand und können in der Zukunft große Bedeutung erlangen.

Zur Herstellung dieser Vorrichtungen werden vielfach sublimierbare organisch funktionale Materialien eingesetzt. Allerdings sind die bisher eingesetzten Pulver und Presslinge mit vielen Nachteilen behaftet. So stauben Pulver beim Vermahlen und Umfüllen, laden sich elektrostatisch auf und demgemäß verbleibt immer ein unerwünschter Rest im Gebinde. Ferner weisen Pulver eine geringe Schüttdichte auf. Presslinge sind sehr aufwändig herzustellen, so dass diese teuer sind. Typischerweise werden Presslinge aus gemahlenem Pulver hergestellt, so dass die zuvor beschriebenen Nachteile grundsätzlich ebenfalls vorhanden sind und mehrere Prozessschritte benötigt werden. Ferner werden die Presslinge einzeln umgefüllt und können fragil sein. Darüber hinaus ist die Staubproblematik nicht vollständig behoben. Durch den Staubanteil sind verstärkt Arbeitsschutzmaßnahmen erforderlich.

Auch bei Verdampferanlagen, bei denen aus einer Schmelze verdampft wird, bestehen Probleme hinsichtlich der Dosierung, da die Schmelze zunächst erhalten werden muss. Je nach Anlage werden Pulver oder Presslinge verwendet, so dass die zuvor dargelegte Problematik ebenfalls vorhanden ist.

Bekannte Pulver und Presslinge, die zur Herstellung von elektronischen Vorrichtungen eingesetzt werden, weisen ein brauchbares Eigenschaftsprofil auf. Allerdings besteht die dauerhafte Notwendigkeit, die Eigenschaften dieser Materialien und Vorrichtungen zu verbessern. Verfahren zur Herstellung von Granulaten werden bereits in den Dokumenten US 4 400 191 A, DE 17 67 615 A1, EP 2 014 355 A1, DE 236 477 C und US 2008/268245 A1 offenbart.

Zu diesen Eigenschaften gehören insbesondere die Verarbeitbarkeit, Transportfähigkeit und Lagerbarkeit von Materialien zur Herstellung von elektronischen Vorrichtungen. Insbesondere sollten die Materialien einen sehr geringen Staubanteil aufweisen und kostengünstig herstellbar sein. Ferner sollten keine besonders hohen Anforderungen an die Arbeitsschutzmaßnahmen bei der Verarbeitung der Materialien erforderlich sein.

Ferner sollte hierbei die Lebensdauer der elektronischen Vorrichtungen und andere Eigenschaften derselben nicht nachteilig durch die Verbesserung der Materialien in zuvor genannter Hinsicht nachteilig beeinflusst werden. Hierzu gehört unter anderem die Energieeffizienz, mit der eine elektronische Vorrichtung die vorgegebene Aufgabe löst. Bei organischen Leuchtdioden sollte insbesondere die Lichtausbeute hoch sein, so dass zum Erreichen eines bestimmten Lichtflusses möglichst wenig elektrische Leistung aufgebracht werden muss. Weiterhin sollte auch zum Erzielen einer vorgegebenen Leuchtdichte eine möglichst geringe Spannung notwendig sein.

Eine weitere Aufgabe kann darin gesehen werden, elektronische Vorrichtungen mit einer ausgezeichneten Leistungsfähigkeit möglichst kostengünstig und in konstanter Qualität bereitzustellen.

Weiterhin sollten die elektronischen Vorrichtungen für viele Zwecke eingesetzt oder angepasst werden können. Insbesondere sollte die Leistungsfähigkeit der elektronischen Vorrichtungen über einen breiten Temperaturbereich erhalten bleiben.

Aufgabe der vorliegenden Erfindung ist weiterhin die Bereitstellung von Materialien, welche sich für den Einsatz in einer organischen elektronischen Vorrichtung, insbesondere in einer organischen Elektrolumineszenzvorrichtung eignen, und welche bei Verwendung in dieser Vorrichtung zu guten Device-Eigenschaften führen, sowie die Bereitstellung der entsprechenden elektronischen Vorrichtung.

Überraschend wurde gefunden, dass bestimmte, nachfolgend näher beschriebene Verfahren diese Aufgaben lösen und den Nachteil aus dem Stand der Technik beseitigen. Die Bildung eines Feinanteils lässt sich umgehen, wenn das Material aus der Schmelze in eine dosierbare Form gebracht wird. Hierdurch können insbesondere Verbesserungen hinsichtlich der Verarbeitbarkeit, der Transportfähigkeit und der Lagerbarkeit von Materialien zur Herstellung von elektronischen Vorrichtungen erzielt werden. Hierbei führt die Verwendung von Granulat zu sehr guten Eigenschaften organischer elektronischer Vorrichtungen, insbesondere von organischen Elektrolumineszenzvorrichtungen, insbesondere hinsichtlich der Lebensdauer, der Effizienz und der Betriebsspannung. Elektronische Vorrichtungen, insbesondere organische Elektrolumineszenzvorrichtungen, welche durch derartige Granulate erhalten werden, sowie die entsprechenden bevorzugten Ausführungsformen sind daher Gegenstand der vorliegenden Erfindung.

Gegenstand der vorliegenden Erfindung ist daher ein Verfahren zur Herstellung von Granulat, enthaltend

mindestens ein funktionales Material (FM), welches zur Herstellung von Funktionsschichten elektronischer Vorrichtungen einsetzbar ist, umfassend die Schritte:

A) Bereitstellung einer Schmelze eines funktionalen Materials, welches zur Herstellung von Funktionsschichten elektronischer Vorrichtungen einsetzbar ist;
B) Überführen der unter A) erhaltenen Schmelze in ein Fallrohr;
C) Abkühlen der in das Fallrohr gemäß Schritt B) überführten Schmelze

unter Erhalt eines Granulats, wobei der Druck bei dem die Schmelze in ein Fallrohr gemäß Schritt B) überführt wird, höher ist als der Druck im Fallrohr, wobei der Druck im Aufgabegefäß im Bereich von 400 bis 700 mbar liegt und der absolute Druck im Fallrohr im Bereich von 250 bis 500 mbar liegt, wobei die in das Fallrohr gemäß Schritt B) überführte Schmelze in Schritt C) mit einem Inertgas abgekühlt wird und wobei das gemäß Schritt C) erhaltene Granulat einen Feinanteil, der durch Partikel mit einem Durchmesser kleiner als 0,1 mm gebildet wird, kleiner 0,1 Gew.-% aufweist.

Das zur Herstellung des Granulats verwendete funktionale Material (FM), welches zur Herstellung von Funktionsschichten elektronischer Vorrichtungen einsetzbar ist, kann bevorzugt ausgewählt sein aus der Gruppe bestehend aus fluoreszierenden Emittern, phosphoreszierenden Emittern, Emitter mit verzögerter Fluoreszenz (TADF (thermally activated delayed fluorescence)-Emitter), Hostmaterialien, Host Materialien mit verzögerter Fluoreszenz (TADF-Host Materialien), Elektronentransportmaterialien, Excitonenblockiermaterialien, Elektroneninjektionsmaterialien, Lochleitermaterialien, Lochinjektionsmaterialien, n-Dotanden, p-Dotanden, Wide-Band-Gap-Materialien (d.h. Materialien mit einem großen Abstand zwischen dem HOMO- und LUMO-Energieniveau, wobei der Abstand bevorzugt größer oder gleich 2,8 eV, ganz bevorzugt größer oder gleich 3.0 eV, besonders bevorzugt größer oder gleich 3.3eV und ganz besonders bevorzugt größer oder gleich 3.5 eV ist), Elektronenblockiermaterialien, Lochblockiermaterialien und/oder Materialien, die Flüssigkristalline Eigenschaften besitzen. Diese funktionalen Materialien (FM) können einzeln oder als Mischung eingesetzt werden oder in dem Granulat enthalten sein. Das funktionale Material (FM), welches zur Herstellung von Funktionsschichten elektronischer Vorrichtungen einsetzbar ist, ist vorzugsweise ein organisches Material oder umfasst eine organische Verbindung. Organische Verbindungen enthalten Kohlenstoffatome und vorzugsweise Wasserstoffatome.

TADF-Emitter und TADF-Hosts sind im Stand der Technik gut bekannt und, beispielsweise, in Ye Tao et al., Adv. Mater. 2014, 26, 7931-7958, M. Y. Wong et al., Adv. Mater. 2017, 29, 1605444, WO 2011/070963, WO 2012/133188, WO 2015/022974 und WO 2015/098975 offenbart. Typischwerweise weisen TADF-Emitter und -Hosts einen sehr kleinen Abstand zwischen dem $S_1$-Singulett- und dem $T_1$-Triplett-Energiezustand auf. Bevorzugt ist $\Delta E_{ST}$ bei diesen Materialien kleiner oder gleich 0.5 eV, ganz bevorzugt kleiner oder gleich 0.3 eV und besonders bevorzugt kleiner oder gleich 0.2 eV, wobei $\Delta E_{ST}$ der Abstand zwischen dem $S_1$-Energieniveau und dem $T_1$-Energieniveau ist.

Das funktionale Material (FM) kann beispielsweise als Pulver bereitgestellt werden. Vorzugsweise wird nicht vermahlenes Sublimat oder erstarrte Schmelze eingesetzt. Besonders bevorzugt kann das erfindungsgemäße Verfahren jedoch insbesondere als Schritt bei der Herstellung dieser funktionalen Materialien durchgeführt werden. Vorzugsweise wird daher die Schmelze durch ein Herstellungsverfahren des funktionalen Materials (FM) bereitgestellt.

Vorzugsweise kann vorgesehen sein, dass das funktionale Material (FM), welches zur Herstellung von Funktionsschichten elektronischer Vorrichtungen einsetzbar ist, zersetzungsfrei oberhalb einer Temperatur von 50°C schmelzbar ist.

Ferner kann vorgesehen sein, dass das funktionale Material (FM), welches zur Herstellung von Funktionsschichten elektronischer Vorrichtungen einsetzbar ist, im geschmolzenen Zustand bei Verarbeitungstemperatur einen Abbau von höchstens 0,1 Gew.-% über eine Lagerdauer von 10 Stunden zeigt. Hierbei kann die Verarbeitungstemperatur im Bereich von 50°C bis 500°C liegen. Vorzugsweise zeigt das funktionale Material (FM), welches zur Herstellung von Funktionsschichten elektronischer Vorrichtungen einsetzbar ist, im geschmolzenen Zustand bei einer Temperatur von kleiner 50°C oberhalb des Schmelzpunktes einen Abbau von höchstens 0,1 Gew.-% über eine Lagerdauer von 10 Stunden.

Das in Schritt A) bereitgestellte funktionale Material (FM) wird unter Überdruck in ein Fallrohr überführt. Überdruck bedeutet, dass der Druck im Fallrohr geringer ist als in dem Aufgabegefäß zur Bereitstellung der Schmelze. Vorzugsweise ist der Druck im Aufgabegefäß mindestens 10 mbar, bevorzugt mindestens 20 mbar und speziell bevorzugt mindestens 50 mbar höher als im Fallrohr. In einer besonderen Ausführungsform ist der Druck im Aufgabegefäß höchstens 300 mbar höher als im Fallrohr.

Vorzugsweise wird die in das Fallrohr gemäß Schritt B) überführte Schmelze in Schritt C) mit einem Inertgas abgekühlt. Hierbei weist das Intertgas bevorzugt eine Temperatur von höchstens 0°C auf und liegt bevorzugt im Bereich von -250 bis -20°C speziell bevorzugt im Bereich von -200 bis -70°C.

Inertgase sind Gase, die mit den funktionalen Materialien (FM) keine Reaktion bei den Verfahrensbedingungen eingehen. Vorzugsweise ist das Inertgas Stickstoff oder ein Edelgas, insbesondere Helium, Argon, Neon, Xenon, Kryptonoder eine Mischung umfassend, besonders bevorzugt bestehend aus diesen Gasen.

Ferner kann vorgesehen sein, dass die in das Fallrohr gemäß Schritt B) überführte Schmelze in Schritt C) über eine Fallhöhe von mindestens 50 cm, bevorzugt mindestens 80 cm gekühlt wird. Besonders bevorzugt wird über eine Fallhöhe im Bereich von 80 bis 1500 cm, speziell bevorzugt 100 bis 800 cm gekühlt.

Vorzugsweise kann vorgesehen sein, dass die Schmelze in Schritt B) durch eine Düse in das Fallrohr überführt wird. Hierbei kann die Schmelze in das Fallrohr über eine oder mehrere Düsen eingebracht werden, wobei die Abstände der Düsen vorzugsweise so gewählt werden, dass die über verschiedene Düsen in das Fallrohr eingebrachte Schmelze nicht zusammenlaufen kann. Die Düse weist bevorzugt einen Durchmesser von höchstens 0,9 mm, besonders bevorzugt von höchstens 0,7 mm und speziell bevorzugt von höchstens 0,6 mm auf. Vorzugsweise liegt der Durchmesser der Düse im Bereich von 0,1 bis 0,5 mm, besonders bevorzugt im Bereich von 0,2 bis 0,3 mm.

In einer speziellen Ausgestaltung wird die Schmelze in Schritt B) vorzugsweise mit einem Volumenstrom im Bereich von 0,1 mL pro Minute bis 250 mL pro Minute besonders bevorzugt im Bereich von 1 mL pro Minute bis 150 mL pro Minute in das Fallrohr überführt.

Ferner kann vorgesehen sein, dass das gemäß Schritt C) erhaltene Granulat vorzugsweise einen Durchmesser im Bereich von 0,1 bis 5 mm aufweist, gemessen mit optischen Methoden als numerischer Mittelwert. In einer weiteren Ausführungsform weist das gemäß Schritt C) erhaltene Granulat vorzugsweise einen Durchmesser im Bereich von 0,1 bis 5 mm auf, gemessen gemäß der Siebmethode, wobei mindestens 90% der Granulatteilchen, besonders bevorzugt mindestens 99% der Granulatteilchen einen Durchmesser im Bereich von 0,1 bis 5 mm zeigen, wobei sich die Prozentangabe auf die Partikelzahl beziehen.

Vorzugsweise kann vorgesehen sein, dass das Granulat sphärisch ist. Der Begriff sphärisch bezeichnet im Rahmen der vorliegenden Erfindung, dass die Partikel vorzugsweise eine kugelförmige Gestalt aufweisen, wobei dem Fachmann offensichtlich ist, dass aufgrund der Verfahrensparameter auch Partikel mit anderer Gestalt enthalten sein können, oder dass die Form der Partikel von der idealen Kugelgestalt abweichen kann.

Dementsprechend bedeutet der Begriff sphärisch, dass das Verhältnis von der größten Ausdehnung der Partikel zur geringsten Ausdehnung maximal 4, vorzugsweise maximal 2 beträgt, wobei diese Ausdehnungen jeweils durch den Schwerpunkt der Partikel gemessen werden. Vorzugsweise sind mindestens 70, besonders bevorzugt mindestens 90%, bezogen auf die Zahl der Partikel, sphärisch.

Bei nicht-sphärischem Granulat beziehen sich die zuvor genannten Durchmesser auf die geringste Ausdehnung der Granulatpartikel.

Weiterhin kann vorgesehen sein, dass das gemäß Schritt C) erhaltene Granulat eine Schüttdichte von mindestens 0,6 g/$cm^3$ aufweist. Vorzugsweise beträgt das Verhältnis von Schüttdichte des Granulats zur Dichte des zur Herstellung des Granulats verwendeten Materials mindestens 1:2, bevorzugt mindestens 2:3, besonders bevorzugt mindestens 3:4 und speziell bevorzugt mindestens 5:6.

In einer weiteren Ausgestaltung ist das funktionale Material (FM), welches zur Herstellung von Funktionsschichten elektronischer Vorrichtungen einsetzbar ist, vorzugsweise ausgewählt aus der Gruppe der Phenyle, Fluorene, Indenofluorene, Spirobifluorene, Carbazole, Indenocarbazole, Indolocarbazole, Spirocarbazole, Pyrimidine, Triazine, Lactame, Triarylamine, Dibenzofurane, Dibenzothiene, Imidazole, Benzimidazole, Benzoxazole, Benzthiazole, 5-Aryl-Phenanthridin-6-one, 9,10-Dehydrophenanthrene, Fluoranthene, Anthracene, Benzanthracene, Fluoradene.

Die zur Herstellung der vorliegenden Granulate eingesetzten funktionalen Materialen (FM) stellen vielfach organische Verbindungen dar, welche die zuvor und nachfolgend genannten Funktionen bereitstellen. Daher sind die Begriffe funktionelle Verbindung beziehungsweise funktionales Material vielfach synonym zu verstehen.

Organisch funktionale Materialen (FM) werden vielfach über die Eigenschaften der Grenzorbitale beschrieben, die nachfolgend näher dargelegt werden. Molekülorbitale, insbesondere auch das highest occupied molecular orbital (HOMO) und das lowest unoccupied molecular orbital (LUMO), deren Energieniveaus sowie die Energie des niedrigsten Triplettzustands $T_1$ bzw. des niedrigsten angeregten Singulettzustands $S_1$ der Materialien werden über quantenchemische Rechnungen bestimmt. Zur Berechnung organischer Substanzen ohne Metalle wird zuerst eine Geometrieoptimierung mit der Methode "Ground State/Semiempirical/Default Spin/AM1/Charge 0/Spin Singlet" durchgeführt. Im Anschluss erfolgt auf Grundlage der optimierten Geometrie eine Energierechnung. Hierbei wird die Methode "TD-SCF/DFT/Default Spin/B3PW91" mit dem Basissatz "6-31 G(d)" verwendet (Charge 0, Spin Singlet). Für metallhaltige Verbindungen wird die Geometrie über die Methode "Ground State/ Hartree-Fock/Default Spin/LanL2MB/Charge 0/Spin Singlet" optimiert. Die Energierechnung erfolgt analog zu der oben beschriebenen Methode für die organischen Substanzen mit dem Unterschied, dass für das Metallatom der Basissatz "LanL2DZ" und für die Liganden der Basissatz "6-31G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$HOMO(eV) = ((HEh*27.212)-0.9899)/1.1206$$

$$LUMO(eV) = ((LEh*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

Die hierin beschriebene Methode ist unabhängig von dem verwendeten Softwarepaket und liefert immer dieselben Ergebnisse. Beispiele oft benutzter Programme für diesen Zweck sind "Gaussian09W" (Gaussian Inc.) und Q-Chem 4.1 (Q-Chem, Inc.).

Verbindungen mit Lochinjektionseigenschaften, hierin auch Lochinjektionsmaterialien genannt, erleichtern oder ermöglichen die Übertragung von Löchern, d. h. positive Ladungen, aus der Anode in eine organische Schicht. Im Allgemeinen weist ein Lochinjektionsmaterial ein HOMO-Niveau auf, das im Bereich des Niveaus der Anode ist oder darüber liegt, d. h. im Allgemeinen mindestens -5,3 eV.

Verbindungen mit Lochtransportseigenschaften, hierin auch Lochtransportmaterialien genannt, sind in der Lage Löcher, d. h. positive Ladungen, zu transportieren, die im Allgemeinen aus der Anode oder einer angrenzenden Schicht, beispielsweise einer Lochinjektionsschicht injiziert werden. Ein Lochtransportmaterial weist im Allgemeinen ein hohes HOMO-Niveau von vorzugsweise mindestens -5.4 eV auf. Je nach Aufbau einer elektronischen Vorrichtung kann ein Lochtransportmaterial auch als Lochinjektionsmaterial eingesetzt werden.

Zu den bevorzugten Verbindungen, die Lochinjektions- und/oder Lochtransporteigenschaften aufweisen, gehören beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-paradioxin-, Phenoxathiin-, Carbazol-, Azulen-, Thiophen-, Pyrrol- und Furanderivate und weitere O-, S- oder N-haltige Heterocyclen mit hoch liegendem HOMO (HOMO = höchstes besetztes Molekülorbital).

Insbesondere zu nennen sind als Verbindungen, die Lochinjektions- und/oder Lochtransporteigenschaften aufweisen, Phenylendiamin-Derivate (US 3615404), Arylamin-Derivate (US 3567450), Amino-substituierte Chalcon-Derivate (US 3526501), Styrylanthracen-Derivate (JP-A-56-46234), Polyzyklische aromatische Verbindungen (EP 1009041), Polyarylalkan-Derivate (US 3615402), Fluorenon-Derivate (JP-A-54-110837), Hydrazon-Derivate (US 3717462), Acylhydrazone, Stilben-Derivate (JP-A-61-210363), Silazan-Derivate (US 4950950), Polysilane (JP-A-2-204996), Anilin-Copolymere (JP-A-2-282263), Thiophen-Oligomere (JP Heisei 1 (1989) 211399), Polythiophene, Poly(N-vinylcarbazol) (PVK), Polypyrrole, Polyaniline und andere elektrisch leitende Makromoleküle, Porphyrin-Verbindungen (JP-A-63-2956965, US 4720432), aromatische Dimethyliden-Typ-Verbindungen, Carbazol-Verbindungen wie z.B. CDBP, CBP, mCP, aromatische tertiäre Amin- und Styrylamin-Verbindungen (US 4127412) wie z.B. Triphenylamine vom Benzidin-Typ, Triphenylamine vom Styrylamin-Typ und Triphenylamine vom Diamin-Typ. Auch Arylamin-Dendrimere können verwendet werden (JP Heisei 8 (1996) 193191), monomere Triarylamine (US 3180730), Triarylamine mit einem oder mehreren Vinylradikalen und/oder mindestens einer funktionellen Gruppe mit aktivem Wasserstoff (US 3567450 und US 3658520) oder Tetraaryldiamine (die zwei Tertiäramineinheiten sind über eine Arylgruppe verbunden). Es können auch noch mehr Triarylaminogruppen im Molekül vorhanden sein. Auch Phthalocyanin-Derivate, Naphthalocyanin-Derivate, Butadien-Derivate und Chinolinderivate wie z.B. Dipyrazino[2,3-f:2',3'-h]quinoxalinhexacarbonitril sind geeignet.

Bevorzugt sind aromatische tertiäre Amine mit mindestens zwei Tertiäramin-Einheiten (US 2008/0102311 A1, US 4720432 und US 5061569), wie z.B. NPD ($\alpha$-NPD = 4,4'-bis[N-(1-naphthyl)-N-phenyl-amino]biphenyl) (US 5061569), TPD 232 (= N,N'-Bis-(N,N'-diphenyl-4-aminophenyl)-N,N-diphenyl-4,4'-diamino-1,1'-biphenyl) oder MTDATA (MTDATA oder m-MTDATA= 4, 4', 4"-Tris[3-methylphenyl)phenyl-amino]triphenylamin) (JP-A-4-308688), TBDB (= N,N,N',N'-Tetra(4-biphenyl)diaminobiphenylen), TAPC (= 1,1-Bis(4-di-p-tolylaminophenyl)-cyclohexan), TAPPP (= 1,1-Bis(4-di-p-tolylaminophenyl)-3-phenylpropan), BDTAPVB (= 1,4-Bis[2-[4-[N,N-di(p-tolyl)amino]phenyl]vinyl]benzol), TTB (= N,N,N',N'-Tetra-*p*-tolyl-4,4'-diaminobiphenyl), TPD (= 4,4'-Bis[N-3-methylphenyl]-N-phenylamino)biphenyl), N,N,N',N'-Tetraphenyl-4,4'"-diamino-1,1',4',1",4",1'"-quaterphenyl, ebenso tertiäre Amine mit Carbazol-Einheiten wie z.B. TCTA (= 4-(9H-Carbazol-9-yl)-N,N-bis[4-(9H-carbazol-9-yl)phenyl]benzolamin). Ebenfalls bevorzugt sind Hexaaza-Triphenylen-Verbindungen gemäß US 2007/0092755 A1 sowie Phthalocyanin-Derivate (z.B. $H_2Pc$, CuPc (= Kupfer-Phthalocyanin), CoPc, NiPc, ZnPc, PdPc, FePc, MnPc, ClAlPc, ClGaPc, ClInPc, ClSnPc, $Cl_2SiPc$, (HO)AlPc, (HO)GaPc, VOPc, TiOPc, MoOPc, GaPc-O-GaPc).

Besonders bevorzugt sind folgende Triarylamin-Verbindungen gemäß den Formeln (TA-1) bis (TA-6), die in den Dokumenten EP 1162193 B1, EP 650 955 B1, Synth.Metals 1997, 91(1-3), 209, DE 19646119 A1, WO 2006/122630 A1, EP 1 860 097 A1, EP 1834945 A1, JP 08053397 A, US 6251531 B1, US 2005/0221124, JP 08292586 A, US 7399537 B2, US 2006/0061265 A1, EP 1 661 888 und WO 2009/041635. Die genannten Verbindungen gemäß den Formeln (TA-1) bis

(TA-6) können auch substituiert sein:

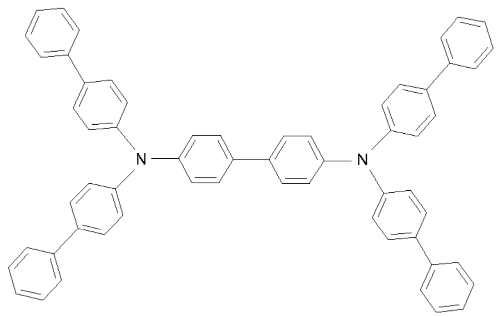

Formel TA-1

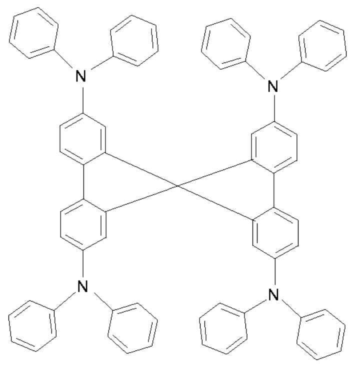

Formel TA-2

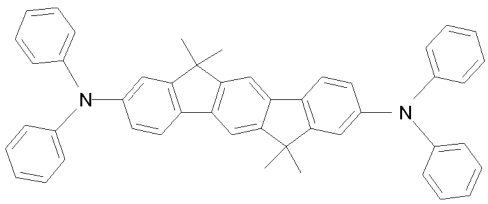

Formel TA-3

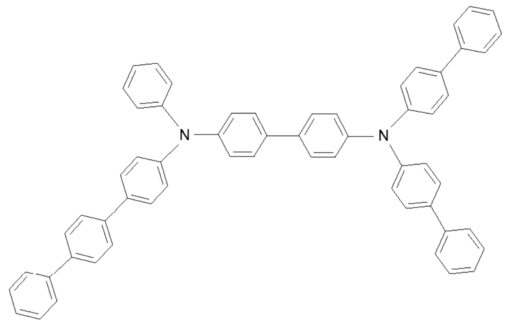

Formel TA-4

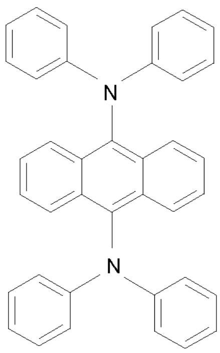

Formel TA-5

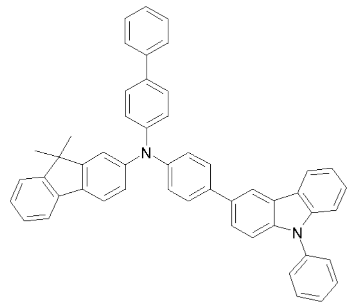

Formel TA-6

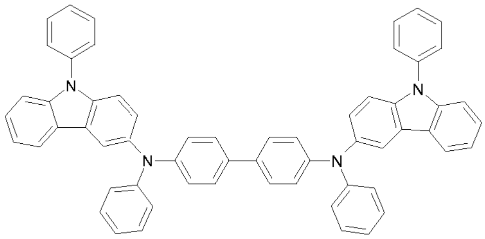

Formel TA-7

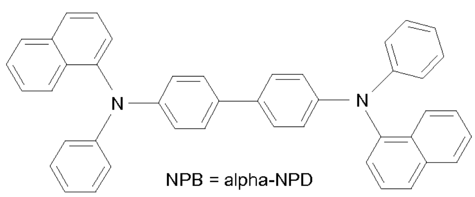

NPB = alpha-NPD

Formel TA-8

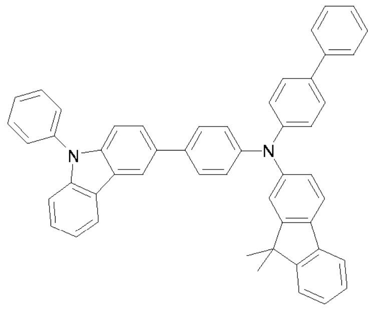

Formel TA-9

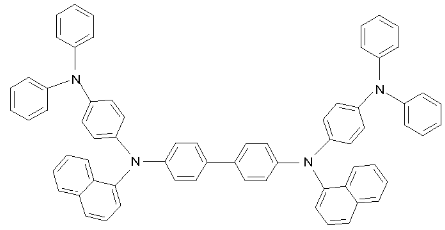

Formel TA-10

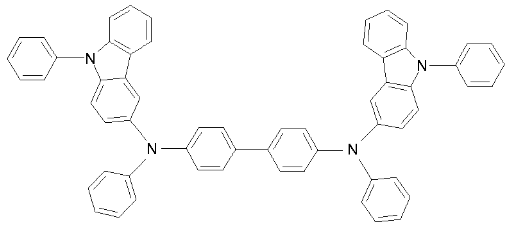

Formel TA-11

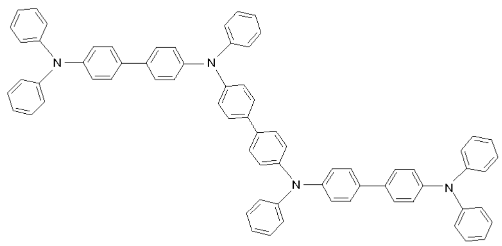

Formel TA-12

Weitere Verbindungen, die als Lochinjektionsmaterialien eingesetzt werden können, sind beschrieben in der EP 0891121 A1 und der EP 1029909 A1, Injektionsschichten allgemein in der US 2004/0174116 A1.

Vorzugsweise führen diese Arylamine und Heterocyclen, die im allgemeinen als Lochinjektions- und/oder Lochtransportmaterialien eingesetzt werden, zu einem HOMO von mehr als -5,8 eV (gegen Vakuumlevel), besonders bevorzugt von mehr als -5,5 eV.

Verbindungen, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital).

Besonders geeignete Verbindungen für elektronentransportierende und elektroneninjizierende Schichten sind Metallchelate von 8-Hydroxychinolin (z.B. LiQ, $AlQ_3$, $GaQ_3$, $MgQ_2$, $ZnQ_2$, $InQ_3$, $ZrQ_4$), BAlQ, Ga-Oxinoid-Komplexe, 4-Azaphenanthren-5-ol-Be-Komplexe (US 5529853 A, vgl. Formel ET-1), Butadienderivate (US 4356429), heterozyklische optische Aufheller (US 4539507), Benzimidazol-Derivate (US 2007/0273272 A1), wie z.B. TPBI (US 5766779, vgl. Formel ET-2), 1,3,5-Triazine, z.B. Spirobifluoren-Triazin-Derivate (z.B. gemäß der DE 102008064200), Pyrene, Anthracene, Tetracene, Fluorene, Spirofluorene, Dendrimere, Tetracene (z.B. Rubren-Derivate), 1,10-Phenanthrolin-Derivate (JP 2003-115387, JP 2004-311184, JP-2001-267080, WO 2002/043449), SilaCyclopentadien-Derivate (EP 1480280, EP 1478032, EP 1469533), Boran-Derivate wie z.B. Triarylboranderivate mit Si (US 2007/0087219 A1, vgl. Formel ET-3), Pyridin-Derivate (JP 2004-200162), Phenanthroline, vor allem 1,10-Phenanthrolinderivate, wie z.B. BCP und Bphen, auch mehrere über Biphenyl oder andere aromatische Gruppen verbundene Phenanthroline (US-2007-0252517 A1) oder mit Anthracen verbundene Phenanthroline (US 2007-0122656 A1, vgl. Formeln ET-4 und ET-5).

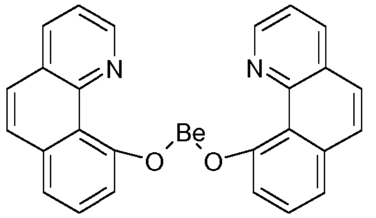

Formel ET-1

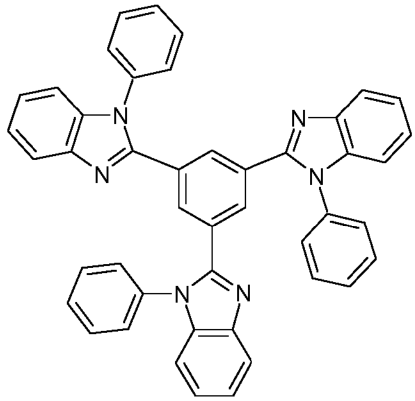

TPBI

2,2',2''-(1,3,5-benzenetriyl)tris(1-phenyl-1H-benzim

Formel ET-2

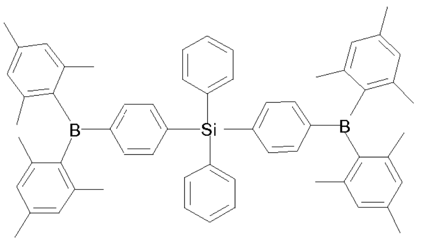

Formel ET-3

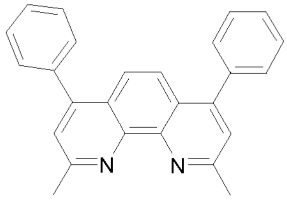

Formel ET-4

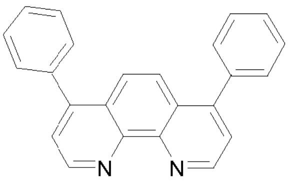

Formel ET-5

Ebenfalls geeignet sind heterozyklische organische Verbindungen wie z.B. Thiopyrandioxide, Oxazole, Triazole, Imidazole oder Oxadiazole. Beispiele für die Verwendung von Fünfringen mit N wie z.B. Oxazole, vorzugsweise 1,3,4-Oxadiazole, beispielsweise Verbindungen gemäß Formeln ET-6, ET-7, ET-8 und ET-9, die unter anderem in US 2007/0273272 A1 dargelegt sind; Thiazole, Oxadiazole, Thiadiazole, Triazole, u.a. siehe US 2008/0102311 A1 und Y.A. Levin, M.S. Skorobogatova, Khimiya Geterotsiklicheskikh Soedinenii 1967 (2), 339-341, vorzugsweise Verbindungen gemäß Formel ET-10, Silacyclopentadien-Derivate. Bevorzugte Verbindungen sind folgende gemäß den Formeln (ET-6) bis (ET-10):

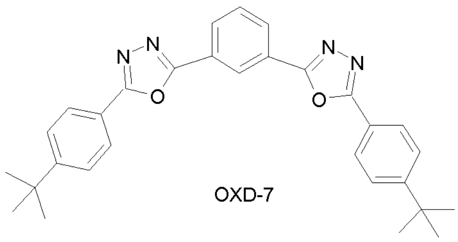

OXD-7

Formel ET-6

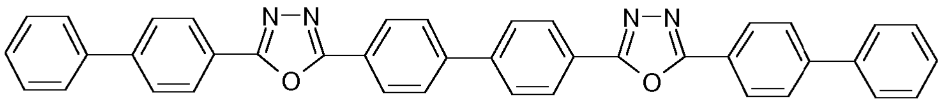

Formel ET-7

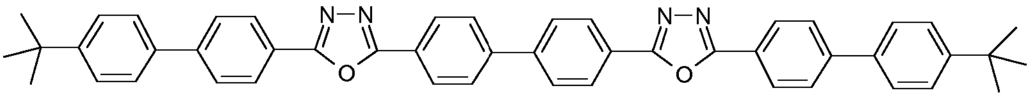

Formel ET-8

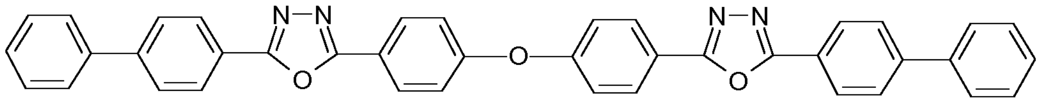

Formel ET-9

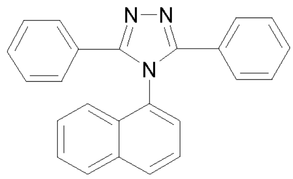

Formel ET-10

Auch organische Verbindungen wie Derivate von Fluorenon, Fluorenylidenmethan, Perylentetrakohlensäure, Anthrachinondimethan, Diphenochinon, Anthron und Anthrachinondiethylendiamin können eingesetzt werden.

Bevorzugt sind 2,9,10-substituierte Anthracene (mit 1- oder 2-Naphthyl und 4- oder 3-Biphenyl) oder Moleküle, die zwei Anthraceneinheiten enthalten (US2008/0193796 A1, vgl. Formel ET-11). Sehr vorteilhaft ist auch die Verbindung von 9,10-substituierten Anthracen-Einheiten mit Benzimidazol-Derivaten (US 2006 147747 A und EP 1551206 A1, vgl. Formeln ET-12 und ET-13).

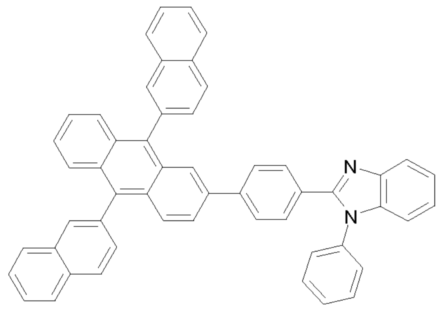

Formel ET-11

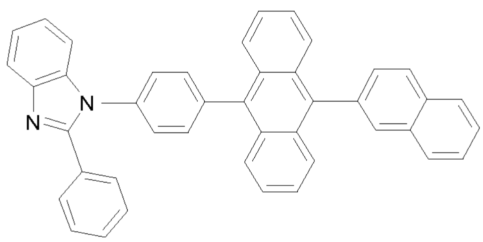

Formel ET-12

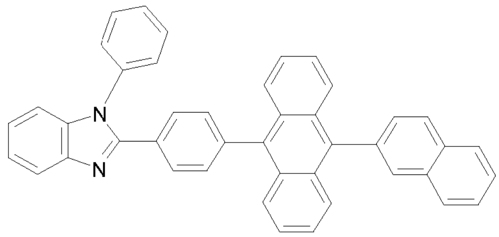

Formel ET-13

Vorzugsweise führen die Verbindungen, die die Elektroneninjektions-und/oder Elektronentransporteigenschaften erzeugen können, zu einem LUMO von weniger als -2,5 eV (gegen Vakuumlevel), besonders bevorzugt von weniger als -2,7 eV.

Die zur Herstellung der vorliegenden Granulate eingesetzten funktionalen Materialien können Emitter umfassen, wobei die erfindungsgemäß einsetzbaren Verbindungen als Emitter ausgestaltet sein können. Der Begriff Emitter bezeichnet ein Material, welches, nach einer Anregung, die durch Übertragung jeder Art von Energie erfolgen kann, einen strahlungsbehafteten Übergang unter Emission von Licht in einen Grundzustand erlaubt. Im Allgemeinen sind zwei Klassen von Emittern bekannt, fluoreszierende (umfassend auch zeitliche verzögerte Fluoreszenz) und phosphoreszierende Emitter. Der Begriff fluoreszierender Emitter bezeichnet Materialien oder Verbindungen, bei welchen ein strahlungsbehafteter Übergang von einem angeregten Singulettzustand in den Grundzustand erfolgt. Der Begriff phosphoreszierender Emitter bezeichnet vorzugsweise lumineszierende Materialien oder Verbindungen, die Übergangsmetalle umfassen.

Emitter werden häufig auch als Dotanden bezeichnet, falls die Dotanden die zuvor dargelegten Eigenschaften in einem System hervorufen. Unter einem Dotanden wird in einem System enthaltend ein Matrixmaterial und einen Dotanden diejenige Komponente verstanden, deren Anteil in der Mischung der kleinere ist. Entsprechend wird unter einem Matrixmaterial in einem System enthaltend ein Matrixmaterial und einen Dotanden diejenige Komponente verstanden, deren Anteil in der Mischung der größere ist. Unter dem Begriff phosphoreszierende Emitter können demgemäß beispielsweise auch phosphoreszierende Dotanden verstanden werden.

Verbindungen, welche Licht emittieren können, umfassen unter anderem fluoreszierende Emitter und phosphoreszierende Emitter. Hierzu gehören unter anderem Verbindungen mit Stilben-, Stilbenamin-, Styrylamin-, Coumarin-, Rubren-, Rhodamin-, Thiazol-, Thiadiazol-, Cyanin-, Thiophen-, Paraphenylen-, Perylen-, Phatolocyanin-, Porphyrin-, Keton-, Chinolin-, Imin-, Anthracen- und/oder Pyren-Strukturen. Besonders bevorzugt sind Verbindungen, die auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o.g. Bedingung erfüllen. Besonders bevorzugt sind hier entsprechende Verbindungen, welche Elemente der Gruppe 8 bis 10 (Ru, Os, Rh, Ir, Pd, Pt) enthalten. Als funktionale Verbindungen kommen hier z.B. verschiedene Komplexe in Frage, wie sie z.B. in der WO 02/068435 A1, der WO 02/081488 A1, der EP 1239526 A2 und der WO 04/026886 A2 beschrieben werden.

Nachfolgend werden beispielhaft bevorzugte Verbindungen dargelegt, die als fluoreszierende Emitter dienen können. Bevorzugte fluoreszierende Emitter sind ausgewählt aus der Klasse der Monostyrylamine, der Distyrylamine, der Tristyrylamine, der Tetrastyrylamine, der Styrylphosphine, der Styrylether und der Arylamine.

Unter einem Monostyrylamin wird eine Verbindung verstanden, die eine substituierte oder unsubstituierte Styrylgruppe und mindestens ein, bevorzugt aromatisches, Amin enthält. Unter einem Distyrylamin wird eine Verbindung verstanden, die zwei substituierte oder unsubstituierte Styrylgruppen und mindestens ein, bevorzugt aromatisches, Amin enthält. Unter einem Tristyrylamin wird eine Verbindung verstanden, die drei substituierte oder unsubstituierte Styrylgruppen und mindestens ein, bevorzugt aromatisches, Amin enthält. Unter einem Tetrastyrylamin wird eine Verbindung verstanden, die vier substituierte oder unsubstituierte Styrylgruppen und mindestens ein, bevorzugt aromatisches, Amin enthält. Die Styrylgruppen sind besonders bevorzugt Stilbene, die auch noch weiter substituiert sein können. Entsprechende Phosphine und Ether sind in Analogie zu den Aminen definiert. Unter einem Arylamin bzw. einem aromatischen Amin im Sinne der vorliegenden Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, vorzugsweise mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden

sind, vorzugsweise in 2,6- oder 9,10-Position. Aromatische Pyrenamine, Pyrendiamine, Chrysenamine und Chrysendiamine sind analog dazu definiert, wobei die Diarylaminogruppen am Pyren vorzugsweise in 1-Position bzw. in 1,6-Position gebunden sind.

Weitere bevorzugte fluoreszierende Emitter sind ausgewählt aus Indenofluorenaminen bzw. -diaminen, die unter anderem im Dokument WO 06/122630 dargelegt sind; Benzoindenofluorenaminen bzw. -diaminen, die unter anderem im Dokument WO 2008/006449 dargelegt sind; und Dibenzoindenofluorenaminen bzw. -diaminen, die unter anderem im Dokument WO 2007/140847 dargelegt sind.

Beispiele für Verbindungen, die als fluoreszierende Emitter eingesetzt werden können, aus der Klasse der Styrylamine sind substituierte oder unsubstituierte Tristilbenamine oder die Dotanden, die in der WO 06/000388, der WO 06/058737, der WO 06/000389, der WO 07/065549 und der WO 07/115610 beschrieben sind. Distyrylbenzol- und Distyrylbiphenyl-Derivate sind beschrieben in der US 5121029. Weitere Styrylamine sind in der US 2007/0122656 A1 zu finden.

Besonders bevorzugte Styrylamin-Verbindungen die in US 7250532 B2 beschriebenen Verbindungen der Formel EM-1 und die in DE 10 2005 058557 A1 dargelegten Verbindungen der Formel EM-2 sind:

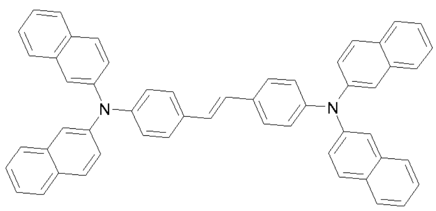

Formel EM-1

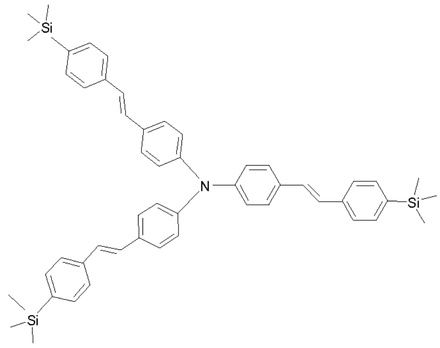

Formel EM-2

Besonders bevorzugte Triarylamin-Verbindungen beziehungsweise -Gruppen oder -Strukturelemente sind die in den Druckschriften CN 1583691 A, JP 08/053397 A und US 6251531 B1, EP 1957606 A1, US 2008/0113101 A1, US 2006/210830 A , WO 08/006449 und DE 102008035413 dargelegten Verbindungen der Formeln EM-3 bis EM-15 und deren Derivate:

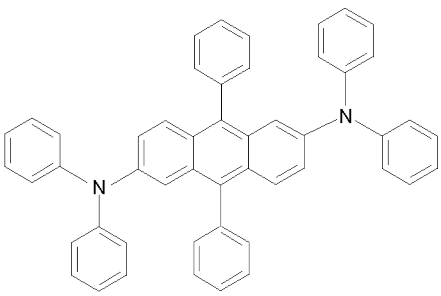

Formel EM-3

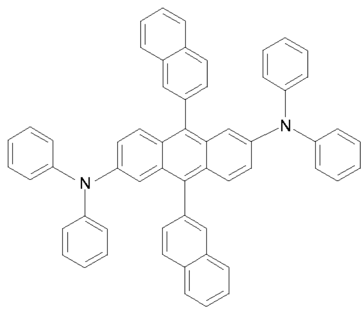

Formel EM-4

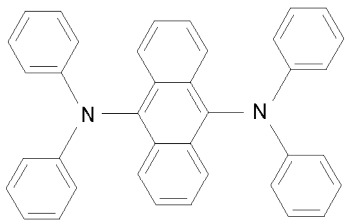

Formel EM-5

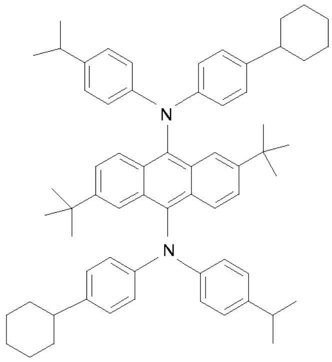

Formel EM-6

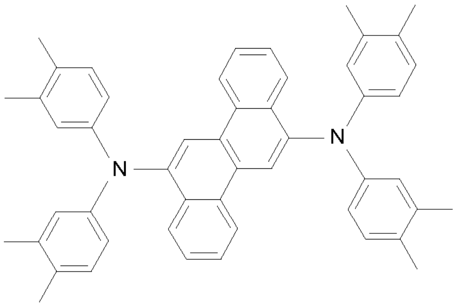

Formel EM-7

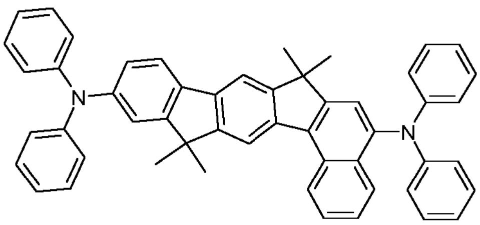

Formel EM-8

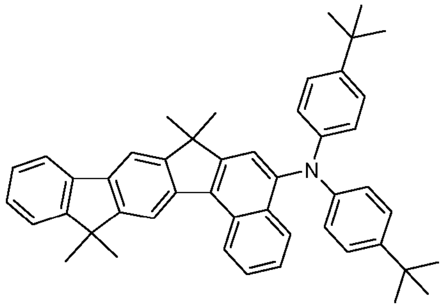

Formel EM-9

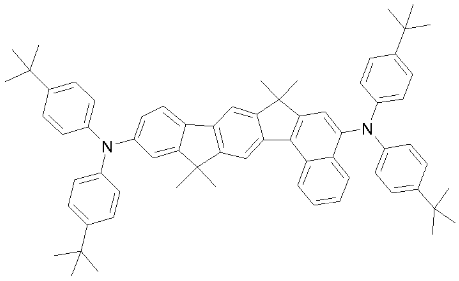

Formel EM-10

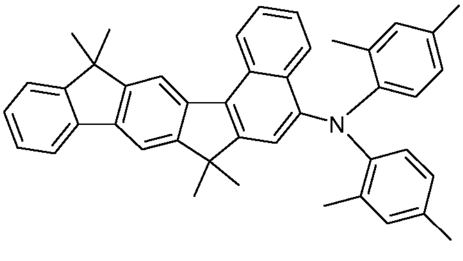

Formel EM-11

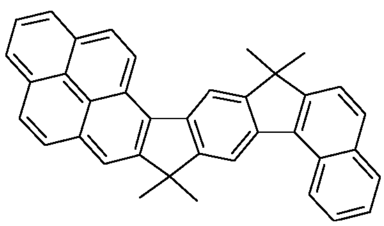

Formel EM-12

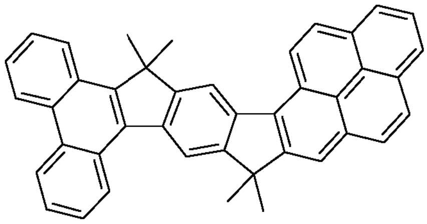

Formel EM-13

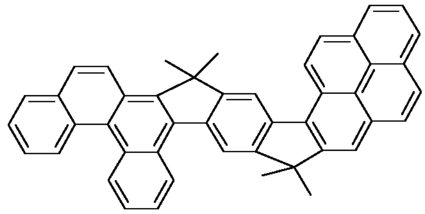

Formel EM-14

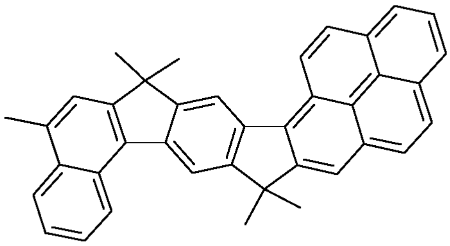

Formel EM-15

Weitere bevorzugte Verbindungen, die als fluoreszierenden Emitter eingesetzt werden können, sind ausgewählt aus Derivaten von Naphthalin, Anthracen, Tetracen, Benzanthracen, Benzphenanthren (DE 10 2009 005746), Fluoren, Fluoranthen, Periflanthen, Indenoperylen, Phenanthren, Perylen (US 2007/0252517 A1), Pyren, Chrysen, Decacyclen, Coronen, Tetraphenylcyclopentadien, Pentaphenylcyclopentadien, Fluoren, Spirofluoren, Rubren, Cumarin (US 4769292, US 6020078, US 2007/0252517 A1), Pyran, Oxazol, Benzoxazol, Benzothiazol, Benzimidazol, Pyrazin, Zimtsäureestern, Diketopyrrolopyrrol, Acridon und Chinacridon (US 2007/0252517 A1).

Von den Anthracenverbindungen sind besonders bevorzugt in 9,10-Position substituierte Anthracene wie z.B. 9,10-Diphenylanthracen und 9,10-Bis(phenylethynyl)anthracen. Auch 1,4-Bis(9'-ethynylanthracenyl)-benzol ist ein bevorzugter Dotand.

Ebenfalls bevorzugt sind Derivate von Rubren, Cumarin, Rhodamin, Chinacridon wie z.B. DMQA (= N,N'-dimethylchinacridon), Dicyanomethylenpyran wie z.B. DCM (= 4-(dicyanoethylen)-6-(4-dimethylamino-styryl-2-methyl)-4H-pyran), Thiopyran, Polymethin, Pyrylium- und Thiapyryliumsalzen, Periflanthen und Indenoperylen.

Blaue Fluoreszenzemitter sind vorzugsweise Polyaromaten wie z.B. 9,10-Di(2-naphthylanthracen) und andere Anthracen-Derivate, Derivate von Tetracen, Xanthen, Perylen wie z.B. 2,5,8,11-Tetra-*t*-butyl-ρerylen, Phenylen, z.B. 4,4'-(Bis(9-ethyl-3-carbazovinylen)-1,1'-biphenyl, Fluoren, Fluoranthen, Arylpyrene (US 2006/0222886 A1), Arylenvinylene (US 5121029, US 5130603), Bis(azinyl)imin-Bor-Verbindungen (US 2007/0092753 A1), Bis(azinyl)methenverbindungen und Carbostyryl-Verbindungen.

Weitere bevorzugte blaue Fluoreszenzemitter sind in C.H.Chen et al.:"Recent developments in organic electroluminescent materials" Macromol. Symp. 125, (1997) 1-48 und "Recent progress of molecular organic electroluminescent materials and devices" Mat. Sci. and Eng. R, 39 (2002), 143-222 beschrieben.

Weitere bevorzugte blau fluoreszierende Emitter sind die in der DE 102008035413 offenbarten Kohlenwasserstoffe. Besonders bevorzugt sind ferner, die in WO 2014/111269 dargelegten Verbindungen, insbesondere Verbindungen mit einem Bis-Indenofluoren-Grundgerüst.

Nachfolgend werden beispielhaft bevorzugte Verbindungen dargelegt, die als phosphoreszierende Emitter dienen können.

Beispiele für phosphoreszierende Emitter können der WO 00/70655, der WO 01/41512, der WO 02/02714, der WO 02/15645, der EP 1191613, der EP 1191612, der EP 1191614 und der WO 05/033244 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden. Phosphoreszierende Metallkomplexe enthalten vorzugsweise Ir, Ru, Pd, Pt, Os oder Re.

Bevorzugte Liganden sind 2-Phenylpyridin-Derivate, 7,8-Benzochinolin-Derivate, 2-(2-Thienyl)pyridin-Derivate, 2-(1-Naphthyl)pyridin-Derivate, 1-Phenylisochinolin-Derivate, 3-Phenylisochinolin-Derivate oder 2-Phenylchinolin-Derivate. Alle diese Verbindungen können substituiert sein, z.B. für Blau mit Fluor-, Cyano- und/oder Trifluormethylsubstituenten. Auxiliäre Liganden sind vorzugsweise Acetylacetonat oder Picolinsäure.

Insbesondere sind Komplexe von Pt oder Pd mit tetradentaten Liganden gemäß Formel EM-16 als Emitter geeigent.

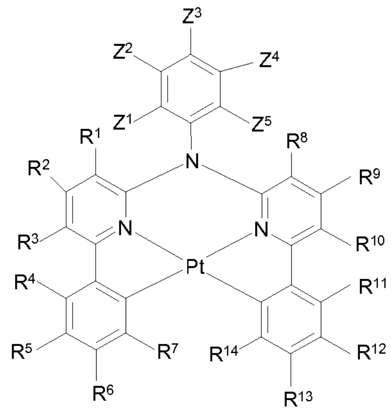

Formel EM-16

Die Verbindungen gemäß Formel EM-16 sind detaillierter in US 2007/0087219 A1 dargelegt, wobei zur Erläuterung der Substituenten und Indices in obiger Formel auf diese Druckschrift zu Offenbarungszwecken verwiesen wird. Weiterhin sind Pt-Porphyrinkomplexe mit vergrößertem Ringsystem (US 2009/0061681 A1) und Ir-Komplexe geeignet, z.B. 2,3,7,8,12,13,17,18-Octaethyl-21H, 23H-porphyrin-Pt(II), Tetraphenyl-Pt(II)-tetrabenzoporphyrin (US 2009/0061681 A1), cis-Bis(2-phenylpyridinato-N,$C^{2'}$)Pt(II), *cis*-Bis(2-(2'-thienyl)pyridinato-N,$C^{3'}$)Pt(II), *cis*-Bis-(2-(2'-thienyl)chinolinato-N,$C^{5'}$)Pt(II), (2-(4,6-Difluoro-phenyl)pyridinato-N,$C^{2'}$)Pt(II)(acetylacetonat), oder Tris(2-phenylpyridinato-N,$C^{2'}$)Ir(III) (= $Ir(ppy)_3$, grün), Bis(2-phenyl-pyridinato-N,$C^2$)Ir(III)(acetylacetonat) (= $Ir(p_Py)_2$acetylacetonat, grün, US 2001/0053462 A1, Baldo, Thompson et al. Nature 403, (2000), 750-753), Bis(1-phenylisochinolinato-N,$C^{2'}$)(2-phenylpyridinato-N,$C^{2'}$)Iridium(III), Bis(2-phenylpyridinato-N,$C^{2'}$)(1-phenylisochinolinato-N,$C^{2'}$)Iridium(III), Bis(2-(2'-benzothienyl)pyridinato-N,$C^{3'}$)Iridium(III)(acetylacetonat), Bis(2-(4',6'-difluorophenyl)pyridinato-N,$C^{2'}$)Iridium(III)(piccolinat) (FIrpic, blau), Bis(2-(4',6'-difluorophenyl)-pyridinato-N,$C^{2'}$)Ir(III)(tetrakis(1-pyrazolyl)borat), Tris(2-(biphenyl-3-yl)-4-tertbutylpyridin)iridium(III), $(ppz)_2$Ir(5ρhdpym) (US 2009/0061681 A1), $(45ooppz)_2$Ir(5ρhdpym) (US 2009/0061681 A1), Derivate von 2-Phenylpyridin-Ir-Komplexen, wie z.B. PQIr (= Iridium(III)-bis(2-phenyl-quinolyl-N,$C^{2'}$)acetylacetonat), Tris(2-phenylisochinolinato-N,C)Ir(III) (rot), Bis(2-(2'-benzo[4,5-a]thienyl)pyridinato-N $C^3$) Ir(acetyl-acetonat) ( [$Btp_2$Ir(acac)], rot, Adachi et al. Appl. Phys. Lett. 78 (2001), 1622-1624). Besonders geeignet sind weiterhin, die in WO 2016/124304 dargelegten Komplexe.

Ebenfalls geeignet sind Komplexe von trivalenten Lanthaniden wie z.B. $Tb^{3+}$ und $Eu^{3+}$ (J.Kido et al. Appl. Phys. Lett. 65 (1994), 2124, Kido et al. Chem. Lett. 657, 1990, US 2007/0252517 A1) oder phosphoreszente Komplexe von Pt(II), Ir(I), Rh(I) mit Maleonitrildithiolat (Johnson et al., JACS 105, 1983, 1795), Re(I)-Tricarbonyl-diimin-Komplexe (Wrighton, JACS 96, 1974, 998 u.a.), Os(II)-Komplexe mit Cyanoliganden und Bipyridyl- oder Phenanthrolin-Liganden (Ma et al., Synth. Metals 94, 1998, 245).

Weitere phosphoreszierende Emitter mit tridentaten Liganden werden beschrieben in der US 6824895 und der US 10/729238. Rot emittierende phosphoreszente Komplexe findet man in der US 6835469 und der US 6830828.

Besonders bevorzugte Verbindungen, die als phosphoreszierende Dotanden Verwendung finden, sind unter anderem die in US 2001/0053462 A1 und Inorg. Chem. 2001, 40(7), 1704-1711, JACS 2001, 123(18), 4304-4312 beschrieben Verbindungen gemäß Formel EM-17 sowie Derivate hiervon.

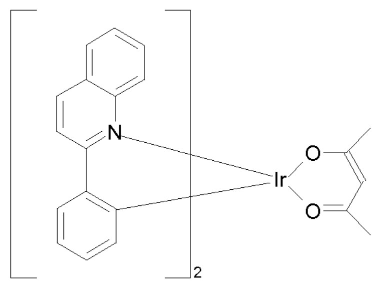

Formel EM-17

Derivate sind beschrieben in der US 7378162 B2, der US 6835469 B2 und der JP 2003/253145 A.

Ferner können die in US 7238437 B2, US 2009/008607 A1 und EP 1348711 beschriebenen Verbindungen gemäß Formel EM-18 bis EM-21 sowie deren Derivate als Emitter eingesetzt werden.

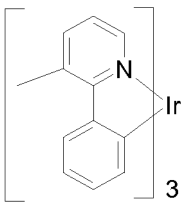

Formel EM-18

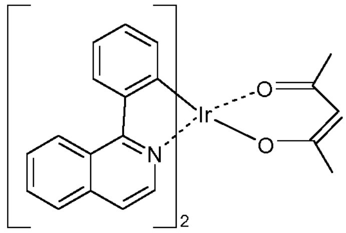

Formel EM-19

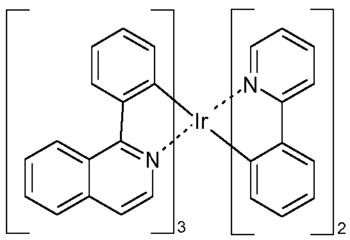

Formel EM-20

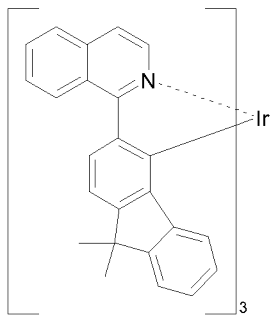

Formel EM-21

Quantum Dots können ebenfalls als Emitter eingesetzt werden, wobei diese Materialien ausführlich in WO 2011/076314 A1 offenbart werden.

Verbindungen, die als Hostmaterialien, insbesondere zusammen mit emittierenden Verbindungen eingesetzt werden, umfassen Materialien verschiedener Stoffklassen.

Hostmaterialien weisen im Allgemeinen größere Bandlücken zwischen HOMO und LUMO auf als die eingesetzten Emittermaterialien. Zusätzlich zeigen bevorzugte Hostmaterialien entweder Eigenschaften eines Loch- oder Elektronentransportmaterials. Weiterhin können Hostmaterialien sowohl Elektronen- als auch Lochtransporteigenschaften aufweisen.

Hostmaterialien werden zum Teil auch als Matrixmaterial bezeichnet, insbesondere falls das Hostmaterial in Kombination mit einem phosphoreszierenden Emitter in einer OLED eingesetzt wird.

Bevorzugte Host-Materialien oder Co-Host-Materialien, die insbesondere zusammen mit fluoreszierenden Dotanden eingesetzt werden, sind ausgewählt aus den Klassen der Oligoarylene (z.B. 2,2',7,7'-Tetraphenylspirobifluoren gemäß EP 676461 oder Dinaphthylanthracen), insbesondere der Oligoarylene enthaltend kondensierte aromatische Gruppen wie z.B. Anthracen, Benzanthracen, Benzphenanthren (DE 10 2009 005746, WO 09/069566), Phenanthren, Tetracen, Coronen, Chrysen, Fluoren, Spirofluoren, Perylen, Phthaloperylen, Naphthaloperylen, Decacyclen, Rubren, der Oligoarylenvinylene (z.B. DPVBi = 4,4'-Bis(2,2-diphenyl-ethenyl)-1,1'-biphenyl ) oder Spiro-DPVBi gemäß EP 676461), der polypodalen Metallkomplexe (z.B. gemäß WO 04/081017), insbesondere Metallkomplexe von 8-Hydroxychinolin, z.B. $AlQ_3$ (= Aluminium(III)tris(8-hydroxychinolin)) oder Bis(2-methyl-8-chinolinolato)-4-(phenylphenolinolato)aluminium, auch mit Imidazol-Chelat (US 2007/0092753 A1) sowie der Chinolin-Metallkomplexe, Aminochinolin-Metallkomplexe, Benzochinolin-Metallkomplexe, der lochleitenden Verbindungen (z.B. gemäß WO 2004/058911), der elektronenleitenden Verbindungen, insbesondere Ketone, Phosphinoxide, Sulfoxide, Carbazole, Spiro-Carbazole, Indenocarbazole, etc. (z.B. gemäß der WO 2005/084081 und der WO 2005/084082), der Atropisomere (z.B. gemäß der WO 06/048268), der Boronsäurederivate (z.B. gemäß der WO 2006/117052) oder der Benzanthracene (z.B. gemäß der WO 2008/145239).

Besonders bevorzugte Verbindungen, die als Host-Materialien oder Co-Host-Materialien dienen können, sind ausgewählt aus den Klassen der Oligoarylene, enthaltend Anthracen, Benzanthracen und/oder Pyren oder Atropisomere dieser Verbindungen. Unter einem Oligoarylen im Sinne der vorliegenden Erfindung soll eine Verbindung verstanden werden, in der mindestens drei Aryl- bzw. Arylengruppen aneinander gebunden sind. Bevorzugte Hostmaterialien sind insbesondere ausgewählt aus Verbindungen der Formel (H-100),

$$Ar^5\text{-}(Ar^6)_p\text{-}Ar^7 \qquad \text{(H-100)}$$

wobei $Ar^5$, $Ar^6$, $Ar^7$ bei jedem Auftreten gleich oder verschieden eine Aryl-oder Heteroarylgruppe mit 5 bis 30 aromatischen Ringatomen ist, die gegebenenfalls substituiert sein kann, und p eine ganze Zahl im Bereich von 1 bis 5 darstellt; dabei gilt,

dass die Summe der π-Elektronen in $Ar^5$, $Ar^6$ und $Ar^7$ mindestens 30 beträgt, wenn p = 1 ist, und mindestens 36 beträgt, wenn p = 2 ist, und mindestens 42 beträgt, wenn p = 3 ist.

Besonders bevorzugt steht in den Verbindungen der Formel (H-100) die Gruppe $Ar^6$ für Anthracen und die Gruppen $Ar^5$ und $Ar^7$ sind in 9- und 10-Position gebunden, wobei diese Gruppen gegebenenfalls substituiert sein können. Ganz besonders bevorzugt ist mindestens eine der Gruppen $Ar^5$ und/oder $Ar^7$ eine kondensierte Arylgruppe, ausgewählt aus 1- oder 2-Naphthyl, 2-, 3- oder 9-Phenanthrenyl oder 2-, 3-, 4-, 5-, 6- oder 7-Benzanthracenyl. Anthracen-basierte Verbindungen sind beschrieben in der US 2007/0092753 A1 und der US 2007/0252517 A1, z.B. 2-(4-Methylphenyl)-9,10-di-(2-naphthyl)anthracen, 9-(2-Naphthyl)-10-(1,1'-biphenyl)anthracen und 9,10-Bis[4-(2,2-diphenylethenyl)phenyl]anthracen, 9,10-Diphenylanthracen, 9,10-Bis(phenylethynyl)anthracen und 1,4-Bis(9'-ethynylanthracenyl)benzol. Bevorzugt sind auch Verbindungen mit zwei Anthraceneinheiten (US 2008/0193796 A1), z.B. 10,10'-Bis[1,1',4', 1"]terphenyl-2-yl-9,9'-bisanthracenyl.

Weitere bevorzugte Verbindungen sind Derivate von Arylamin, Styrylamin, Fluorescein, Diphenylbutadien, Tetraphenylbutadien, Cyclopentadiene, Tetraphenylcyclopentadien, Pentaphenylcyclopentadien, Cumarin, Oxadiazol, Bisbenzoxazolin, Oxazol, Pyridin, Pyrazin, Imin, Benzothiazol, Benzoxazol, Benzimidazol (US 2007/0092753 A1), z.B. 2,2',2"-(1,3,5-Phenylen)tris[1-phenyl-1H-benzimidazol], Aldazin, Stilben, Styrylarylenderivate, z.B. 9,10-Bis[4-(2,2-diphenylethenyl)phenyl]anthracen und Distyrylarylen-Derivate (US 5121029), Diphenylethylen, Vinylanthracen, Diaminocarbazol, Pyran, Thiopyran, Diketopyrrolopyrrol, Polymethin, Zimtsäureestern und Fluoreszenzfarbstoffen.

Besonders bevorzugt sind Derivate von Arylamin und Styrylamin, z.B. TNB (= 4,4'-Bis[N-(1-naphthyl)-N-(2-naphthyl)amino]biphenyl). Metall-Oxinoid-Komplexe wie LiQ oder $AlQ_3$ können als Co-Hosts verwendet werden.

Bevorzugte Verbindungen mit Oligoarylen als Matrix sind in US 2003/0027016 A1, US 7326371 B2, US 2006/043858 A, WO 2007/114358, WO 08/145239, JP 3148176 B2, EP 1009044, US 2004/018383, WO 2005/061656 A1, EP 0681019B1, WO 2004/013073A1, US 5077142, WO 2007/065678 und DE 102009005746 dargelegt, wobei besonders bevorzugte Verbindungen durch die Formeln H-102 bis H-108 beschrieben sind.

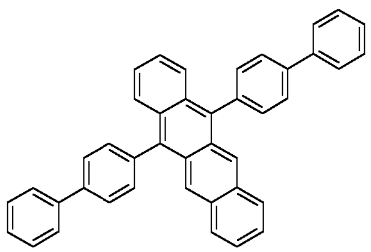

Formel H-102

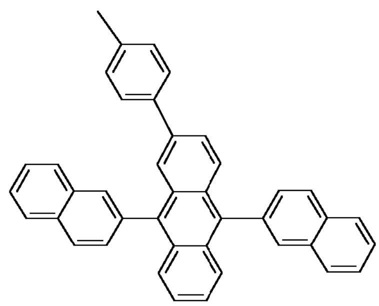

Formel H-103

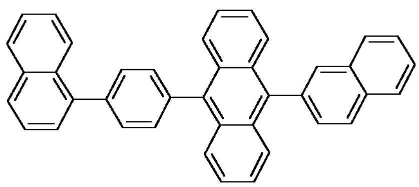

Formel H-104

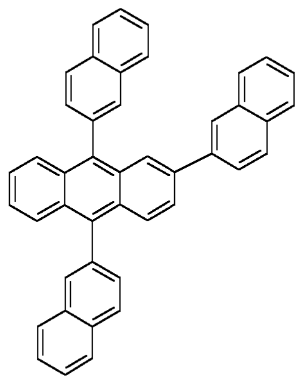

Formel H-105

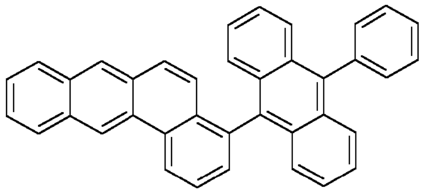

Formel H-106

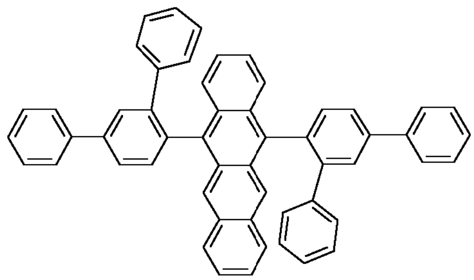

Formel H-107

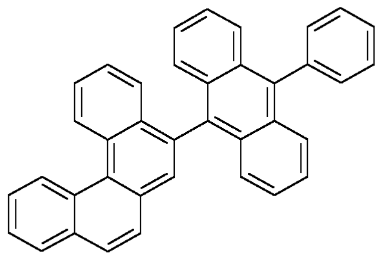

Formel H-108

Weiterhin umfassen Verbindungen, die als Host oder Matrix eingesetzt werden können, Materialien, die zusammen mit phosphoreszierenden Emittern eingesetzt werden. Zu diesen Verbindungen, die auch als Strukturelemente in Polymeren eingesetzt werden können, gehören CBP (N,N-Biscarbazolylbiphenyl), Carbazolderivate (z.B. gemäß WO 05/039246, US 2005/0069729, JP 2004/288381, EP 1205527 oder WO 08/086851), Azacarbazole (z.B. gemäß EP 1617710, EP 1617711, EP 1731584, JP 2005/347160), Ketone (z.B. gemäß WO 04/093207 oder gemäß der DE 102008033943), Phosphinoxide, Sulfoxide und Sulfone (z.B. gemäß WO 05/003253), Oligophenylene, aromatische Amine (z.B. gemäß US 2005/0069729), bipolare Matrixmaterialien (z.B. gemäß WO 07/137725), Silane (z.B. gemäß WO 05/111172), 9,9-Diarylfluorenderivate (z.B. gemäß der DE 102008017591), Azaborole oder Boronester (z.B. gemäß WO 06/117052), Triazin-Derivate (z.B. gemäß der DE 102008036982), Indolocarbazolderivate (z.B. gemäß WO 07/063754 oder WO 08/056746), Indenocarbazolderivate (z.B. gemäß der DE 102009023155 und der DE 102009031021), Diazaphospholderivate (z.B. gemäß der DE 102009022858), Triazol-Derivate, Oxazole und Oxazol-Derivate, Imidazol-Derivate, Polyarylalkan-Derivate, Pyrazolin-Derivate, Pyrazolon-Derivate, Distyrylpyrazin-Derivate, Thiopyrandioxid-Derivate, Phenylendiamin-Derivate, tertiäre aromatische Amine, Styrylamine, Amino-substituierte Chalcon-Derivate, Indole, Hydrazon-Derivate, Stilben-Derivate, Silazan-Derivate, aromatische Dimethyliden-Verbindungen, Carbodiimid-Derivate, Metallkomplexe von 8-Hydroxychinolin-Derivaten wie z.B. $AlQ_3$, die 8-Hydroxychinolin-Komplexe können auch Triarylaminophenol-Liganden enthalten (US 2007/0134514 A1), Metallkomplex-Polysilan-Verbindungen sowie Thiophen-, Benzothiophen- und Dibenzothiophen-Derivate.

Beispiele für bevorzugte Carbazol-Derivate sind mCP (= 1,3-N,N-dicarbazol-benzol (= 9,9'-(1,3-Phenylen) bis-9H-carbazol)) (Formel H-9), CDBP (= 9,9'-(2,2'-Dimethyl[1,1'-biphenyl]-4,4'-diyl)bis-9H-carbazol), 1,3-Bis(N,N'-dicarbazol)benzol (= 1,3-Bis(carbazol-9-yl)benzol), PVK (Polyvinylcarbazol), 3,5-Di(9H-carbazol-9-yl)biphenyl sowie CMTTP (Formel H10). Besonders bevorzugte Verbindungen sind in US 2007/0128467 A1 und US 2005/0249976 A1 dargelegt (Formeln H-111 bis H-113).

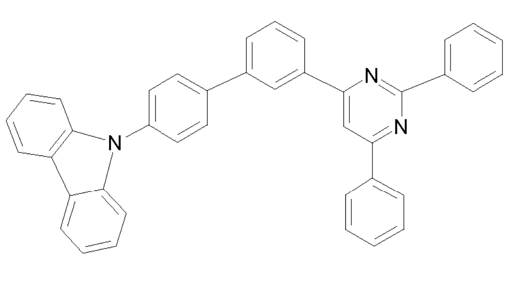

Formel H-109

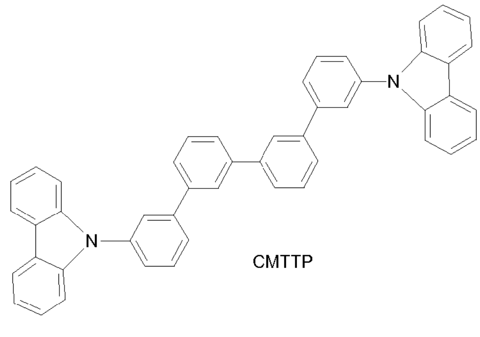

CMTTP

Formel H-110

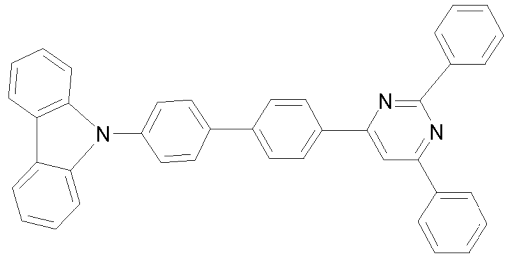

Formel H-111

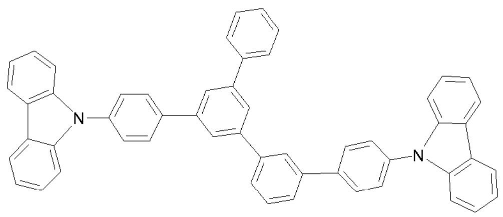

Formel H-112

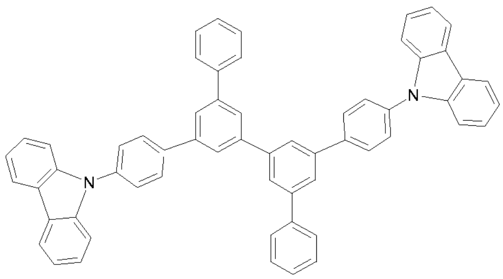

Formel H-113

Bevorzugte Si-Tetraaryle werden z.B. in den Dokumenten US 2004/0209115, US 2004/0209116, US 2007/0087219 A1 und H. Gilman, E.A. Zuech, Chemistry & Industry (London, United Kingdom), 1960, 120 dargelegt. Besonders bevorzugte Si-Tetraaryle werden durch die Formeln H-114 bis H-120 beschrieben.

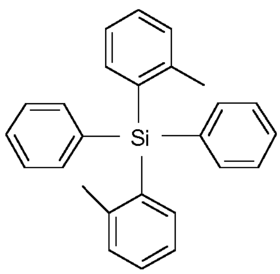

UGH1

Formel H-114

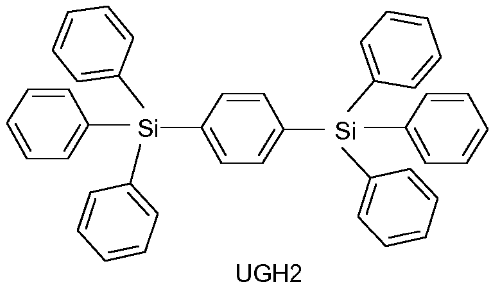

UGH2

Formel H-115

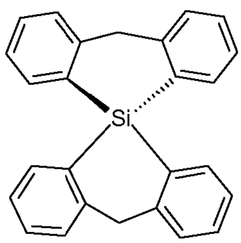

UGH4

Formel H-116

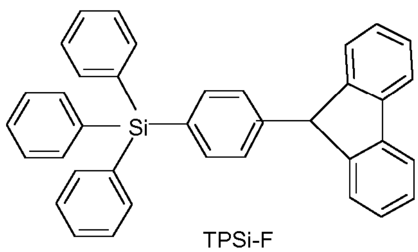

TPSi-F

Triphenyl-[4-(9-phenyl-9H-fluoren-9-yl)phenyl]silane

Formel H-117

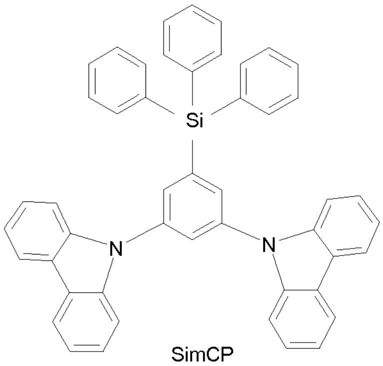

SimCP

Formel H-117

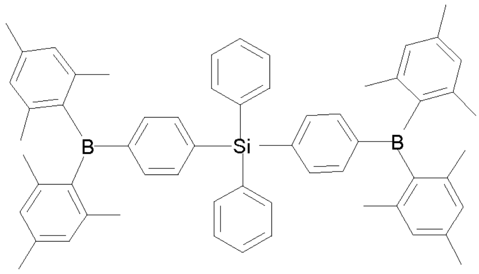

Formel H-118

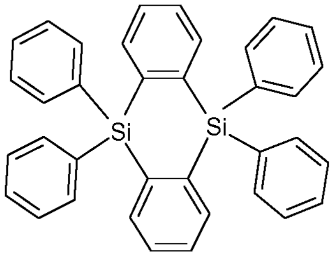

Formel H-119

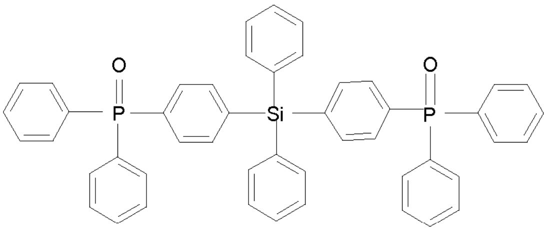

Formel H-120

Besonders bevorzugte Verbindungen zur Herstellung der Matrix für phosphoreszierende Dotanden sind unter anderem in DE 102009022858, DE 102009023155, EP 652273 B1, WO 2007/063754 und WO 2008/056746 dargelegt, wobei besonders bevorzugte Verbindungen durch die Formeln H-121 bis H-124 beschrieben werden.

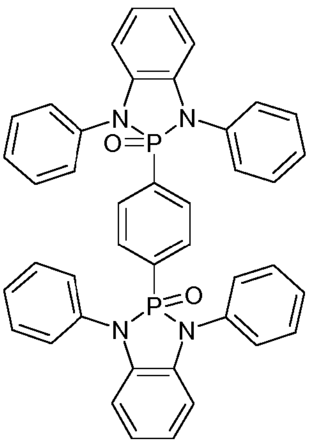

Formel H-121

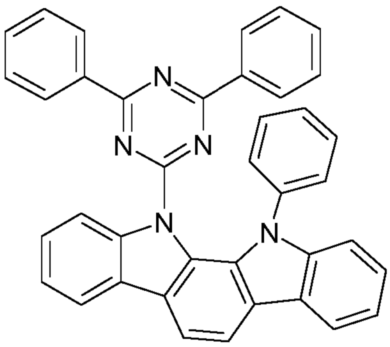

Formel H-122

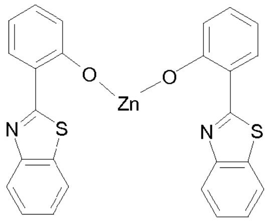

Formel H-123

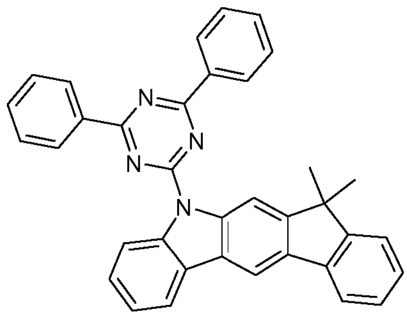

Formel H-124

Im Hinblick auf die erfindungsgemäß einsetzbaren funktionalen Verbindungen, die als Hostmaterial dienen können, sind insbesondere Stoffe bevorzugt, die mindestens ein Stickstoffatom aufweist. Hierzu gehören vorzugsweise aromatische Amine, Triazin- und Carbazol-Derivate. So zeigen insbesondere Carbazol-Derivate eine überraschend hohe Effizienz. Triazin-Derivate führen unerwartet zu hohen Lebensdauern der elektronischen Vorrichtungen mit den genannten Verbindungen.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin können Verbindungen eingesetzt werden, welche den Übergang vom Singulett- zum Triplettzustand verbessern und welche, unterstützend zu den funktionalen Verbindungenn mit Emittereigenschaften eingesetzt, die Phosphoreszenzeigenschaften dieser Verbindungen verbessern. Hierfür kommen insbesondere Carbazol- und überbrückte Carbazoldimereinheiten in Frage, wie sie z.B. in der WO 04/070772 A2 und der WO 04/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 05/040302 A1 beschrieben werden.

Unter n-Dotanden werden hierin Reduktionsmittel, d.h. Elektronendonatoren verstanden. Bevorzugte Beispiele für n-Dotanden sind W(hpp)4 und weitere elektronenreiche Metallkomplexe gemäß WO 2005/086251 A2, P=N-Verbindungen (z.B. WO 2012/175535 A1, WO 2012/175219 A1), Naphthylencarbodiimide (z.B. WO 2012/168358 A1), Fluorene (z.B. WO 2012/031735 A1), Radikale und Diradikale (z.B. EP 1837926 A1, WO 2007/107306 A1), Pyridine (z.B. EP 2452946 A1, EP 2463927 A1), N-heterocyclische Verbindungen (z.B. WO 2009/000237 A1) und Acridine sowie Phenazine (z.B. US 2007/145355 A1).

Weiterhin können die zur Herstellung der erfindungsgemäßen Granulate einsetzbaren Verbindungen als Wide-Band-Gap-Material ausgestaltet sein. Unter Wide-Band-Gap-Material wird ein Material im Sinne der Offenbarung von US 7,294,849 verstanden. Diese Systeme zeigen besondere vorteilhafte Leistungsdaten in elektrolumineszierenden Vorrichtungen.

Vorzugsweise kann die als Wide-Band-Gap-Material eingesetzte Verbindung eine Bandlücke (band gap) von 2.5 eV oder mehr, bevorzugt 3.0 eV oder mehr, ganz bevorzugt von 3.5 eV oder mehr aufweisen. Die Bandlücke kann unter anderem durch die Energieniveaus des highest occupied molecular orbital (HOMO) und des lowest unoccupied molecular orbital (LUMO) berechnet werden.

Weiterhin können die zur Herstellung der erfindungsgemäßen Granulate einsetzbaren Verbindungen als Lochblockiermaterial (hole blocking material; HBM) ausgestaltet sein. Ein Lochblockiermaterial bezeichnet ein Material welches in einem Mehrschichtverbund die Durchleitung von Löchern (positive Ladungen) verhindert oder minimiert, insbesondere falls dieses Material in Form einer Schicht benachbart zu einer Emissionsschicht oder eine lochleitenden Schicht angeordnet ist. Im Allgemeinen hat ein Lochblockiermaterial ein niedrigeres HOMO Niveau als das Lochtransportmaterial in der benachbarten Schicht. Lochblockierschichten werden häufig zwischen der lichtemittierenden Schicht und der Elektronentransportschicht in OLEDs angeordnet.

Grundsätzlich kann jedes bekannte Lochblockiermaterial eingesetzt werden. Zusätzlich zu weiteren Lochblockiermaterialien, die an anderen Stellen in der vorliegenden Anmeldung dargelegt werden, sind zweckmäßige Lochblockiermaterialien Metallkomplexe (US 2003/0068528), wie beispielsweise Bis(2-methyl-8-quinolinolato)(4-phenylphenolato)-aluminium(III) (BAIQ). Fac-tris(1-phenylpyrazolato-N,C2)iridium(III) (Ir(ppz)3) wird ebenfalls für diese Zwecke eingesetzt (US 2003/0175553 A1). Phenanthrolin-Derivate, wie beispielsweise BCP, oder Phthalimide, wie beispielsweise TMPP können ebenfalls eingesetzt werden.

Weiterhin werden zweckmäßige Lochblockiermaterialien in WO 00/70655 A2, WO 01/41512 und WO 01/93642 A1 beschrieben.

Weiterhin können die erfindungsgemäß einsetzbaren Verbindungen als Elektronenblockiermaterial (electron blocking material; EBM) ausgestaltet sein. Ein Elektronenblockiermaterial bezeichnet ein Material welches in einem Mehrschichtverbund die Durchleitung von Elektronen verhindert oder minimiert, insbesondere falls dieses Material in Form einer Schicht benachbart zu einer Emissionsschicht oder eine elektronenleitenden Schicht angeordnet ist. Im Allgemeinen hat ein Elektronenblockiermaterial ein höheres LUMO Niveau als das Elektronentransportmaterial in der benachbarten Schicht.

Grundsätzlich kann jedes bekannte Elektronenblockiermaterial eingesetzt werden. Zusätzlich zu weiteren Elektronenblockiermaterialien, die an anderen Stellen in der vorliegenden Anmeldung dargelegt werden, sind zweckmäßige Elektronenblockiermaterialien Übergangsmetall-Komplexe wie beispielsweise Ir(ppz)3 (US 2003/0175553).

Vorzugsweise kann das Elektronenblockiermaterial ausgewählt sein aus Aminen, Triarylaminen und deren Derivativen.

Materialien, die Flüssigkristalline Eigenschaften besitzen, sind als solche weithin in der Fachwelt bekannt. Diese Materialien sind bei

Anwendungstemperatur einerseits flüssig, zeigen jedoch andererseits richtungsabhängige physikalische Eigenschaften.

Weiterhin weisen die funktionalen Materialien (FM), welche zur Herstellung von Funktionsschichten elektronischer Vorrichtungen einsetzbar sind, sofern es sich um niedermolekulare Verbindungen handelt, vorzugsweise ein Molekulargewicht von $\leq$ 3000 g/mol, besonders bevorzugt von $\leq$ 2000 g/mol, insbesondere bevorzugt $\leq$ 1500 g/mol und ganz besonders bevorzugt von $\leq$ 1000 g/mol auf.

Von besonderem Interesse sind des Weiteren funktionale Materialien (FM), welche zur Herstellung von Funktionsschichten elektronischer Vorrichtungen einsetzbar sind, die sich durch eine hohe Glasübergangstemperatur auszeichnen. In diesem Zusammenhang sind Verbindungen, welche zur Herstellung von Funktionsschichten elektronischer Vorrichtungen einsetzbar sind, bevorzugt, die eine Glasübergangstemperatur von $\geq$ 70°C, bevorzugt von $\geq$ 100°C, besonders bevorzugt von $\geq$ 125°C und insbesondere bevorzugt von $\geq$ 150°C aufweisen, bestimmt nach DIN 51005:2005-08.

Unter der Voraussetzung, dass die in Anspruch 1 genannten Bedingungen eingehalten werden, sind die oben genannten bevorzugten Ausführungsformen beliebig miteinander kombinierbar. In einer besonders bevorzugten Ausführungsform der Erfindung gelten die oben genannten bevorzugten Ausführungsformen gleichzeitig.

Die erfindungsgemäß einsetzbaren Verbindungen, welche zur Herstellung von Funktionsschichten elektronischer Vorrichtungen einsetzbar sind, sind prinzipiell durch verschiedene Verfahren darstellbar, wobei diese in den zuvor genannten Druckschriften dargelegt sind.

Die erfindungsgemäß erhältlichen Granulate unterscheiden sich von bekannten Zusammensetzungen dadurch, dass das Granulat einen Feinanteil, der durch Partikel mit einem Durchmesser kleiner als 0,1 mm gebildet wird, kleiner 0,1 Gew.-% aufweist.

Ein weiterer Gegenstand der vorliegenden Erfindung ist daher ein Granulat erhältlich gemäß einem Verfahren der vorliegenden Erfindung.

Die erfindungsgemäßen Granulate können sämtliche organisch funktionalen Materialien enthalten, welche zur Herstellung der jeweiligen Funktionsschicht der elektronischen Vorrichtung notwendig sind. Ist z.B. eine Lochtransport-, Lochinjektions-, Elektronentransport-, Elektroneninjektionsschicht genau aus einer funktionellen Verbindung aufgebaut, so umfasst das Granulat als organisch funktionale Material genau diese Verbindung. Weist eine Emissionsschicht beispielsweise einen Emitter im Kombination mit einem Matrix- oder Hostmaterial auf, so umfasst die Formulierung als organisch funktionales Material genau die Mischung von Emitter und Matrix- oder Hostmaterial, wie dies in der vorliegenden Anmeldung an anderer Stelle ausführlicher dargelegt ist. In einer bevorzugten Ausführungsform enthält das Granulat zwei oder mehr Matrixmaterialien (oder Hostmaterialien), ganz bevorzugt genau zwei Matrixmaterialien (oder Hostmaterialien). Solche Mischungen mehrerer Matrix- oder Hostmaterialien sind dem Fachmann auch als Premixed-Systeme bekannt.

Funktionale Materialen sind generell die organischen oder anorganischen Materialien, welche zwischen Anode und Kathode eingebracht sind. Vorzugsweise ist das organisch funktionale Material ausgewählt aus der Gruppe bestehend aus fluoreszierenden Emittern, phosphoreszierenden Emittern, Emittern, die TADF (thermally activated delayed fluorescence) zeigen, Host-Materialien, Elektronentransportmaterialien, Elektroneninjektionsmaterialien, Lochtransportmaterialien, Lochinjektionsmaterialien, Elektronenblockiermaterialien, Lochblockiermaterialien, Wide-Band-Gap-Materialien, p-Dotanden, n-Dotanden und/oder Materialien, die flüssigkristalline Eigenschaften besitzen, vorzugsweise fluoreszierenden Emittern, phosphoreszierenden Emittern, Emittern, die TADF (thermally activated delayed fluorescence) zeigen, Host-Materialien, Elektronentransportmaterialien, Elektroneninjektionsmaterialien, Lochtransportmaterialien, Lochinjektionsmaterialien, Elektronenblockiermaterialien, Lochblockiermaterialien, Wide-Band-Gap-Materialien, p-Dotanden und/oder n-Dotanden.

Ein weiterer Gegenstand der vorliegenden Erfindung ist die Verwendung von Granulat gemäß der vorliegenden Erfindung zur Herstellung einer elektronischen Vorrichtung.

Unter einer elektronischen Vorrichtung wird eine Vorrichtung verstanden, welche Anode, Kathode und mindestens eine dazwischenliegenden Funktionsschicht enthält, wobei diese Funktionsschicht mindestens eine organische bzw. metallorganische Verbindung enthält.

Die organische, elektronische Vorrichtung ist vorzugsweise eine organische elektrolumineszierende Vorrichtung (OLED), eine polymere elektro-lumineszierende Vorrichtung (PLED), eine organische integrierte Schaltung (O-IC), ein organischer Feld-Effekt-Transistor (O-FET), ein organischer Dünnfilmtransistor (O-TFT), ein organischer, lichtemittierender Transistor (O-LET), eine organische Solarzelle (O-SC), ein organischer, optischer Detektor, ein organischer Fotorezeptor, ein organisches Feld-Quench-Device (O-FQD), ein organisch elektrischer Sensor, eine lichtemittierende elektrochemische Zelle (LEC),eine organische Laserdiode (O-Laser), oder ein flüssigkristallines Display.

Aktive Komponenten sind generell die organischen oder anorganischen Materialien, welche zwischen Anode und Kathode eingebracht sind, wobei diese aktiven Komponenten die Eigenschaften der elektronischen Vorrichtung, beispielsweise deren Leistungsfähigkeit und/oder deren Lebensdauer bewirken, aufrechterhalten und/oder verbessern, beispielsweise Ladungsinjektions-, Ladungstransport- oder Ladungsblockiermaterialien, insbesondere aber Emissionsmaterialien und Matrixmaterialien. Das organisch funktionelle Material, welches zur Herstellung von Funktionsschichten elektronischer Vorrichtungen einsetzbar ist, umfasst demgemäß vorzugsweise eine aktive Komponente der elektronischen Vorrichtung.

Eine bevorzugte Ausführungsform der vorliegenden Erfindung sind organische Elektrolumineszenzvorrichtungen. Die organische Elektrolumineszenzvorrichtung enthält Kathode, Anode und mindestens eine emittierende Schicht.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum.

Der Anteil des Matrixmaterials in der emittierenden Schicht liegt in diesem Fall vorzugsweise zwischen 50 und 99,9 Vol.-%, besonders bevorzugt zwischen 80 und 99,5 Vol.-% und insbesondere bevorzugt für fluoreszierende emittierende Schichten zwischen 92 und 99,5 Vol.-% sowie für phosphoreszierende emittierende Schichten zwischen 85 und 97 Vol.-%.

Entsprechend liegt der Anteil des Dotanden vorzugsweise zwischen 0,1 und 50 Vol.-%, besonders bevorzugt zwischen 0,5 und 20 Vol.-% und insbesondere bevorzugt für fluoreszierende emittierende Schichten zwischen 0,5 und 8 Vol.-% sowie für phosphoreszierende emittierende Schichten zwischen 3 und 15 Vol.-%.

Eine emittierende Schicht einer organischen Elektrolumineszenzvorrichtung kann auch Systeme umfassen, die mehrere Matrixmaterialien (Mixed-Matrix-Systeme) und/oder mehrere Dotanden enthalten. Auch in diesem Fall sind die Dotanden im Allgemeinen diejenigen Materialien, deren Anteil im System der kleinere ist und die Matrixmaterialien sind diejenigen Materialien, deren Anteil im System der größere ist. In Einzelfällen kann jedoch der Anteil eines einzelnen Matrixmaterials im System kleiner sein als der Anteil eines einzelnen Dotanden.

Die Mixed-Matrix-Systeme umfassen bevorzugt zwei oder drei verschiedene Matrixmaterialien, besonders bevorzugt zwei verschiedene Matrixmaterialien. Bevorzugt stellt dabei eines der beiden Materialien ein Material mit lochtransportierenden Eigenschaften und das andere Material ein Material mit elektronentransportierenden Eigenschaften dar. Die gewünschten elektronentransportierenden und lochtransportierenden Eigenschaften der Mixed-Matrix-Komponenten können jedoch auch hauptsächlich oder vollständig in einer einzigen Mixed-Matrix-Komponente vereinigt sein, wobei die weitere bzw. die weiteren Mixed-Matrix-Komponenten andere Funktionen erfüllen. Die beiden unterschiedlichen Matrixmaterialien können dabei in einem Verhältnis von 1:50 bis 1:1, bevorzugt von 1:20 bis 1:1, besonders bevorzugt von 1:10 bis 1:1 und insbesondere bevorzugt von 1:4 bis 1:1 vorliegen. Bevorzugt werden Mixed-Matrix-Systeme in phosphoreszierenden organischen Elektrolumineszenzvorrichtungen eingesetzt. Detailliertere Angaben zu Mixed-Matrix-Systemen finden sich z.B. in der WO 2010/108579.

Außer diesen Schichten kann eine organische Elektrolumineszenzvorrichtung noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten (Charge-Generation Layers, IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer*)* und/oder organische oder anorganische p/n-Übergänge. Dabei ist es möglich, dass eine oder mehrere Lochtransportschichten p-dotiert sind, beispielsweise mit Metalloxiden, wie $MoO_3$ oder $WO_3$ oder mit (per)fluorierten elektronenarmen Aromaten, und/oder dass eine oder mehrere Elektronentransportschichten n-dotiert sind. Ebenso können zwischen zwei emittierende Schichten Interlayer eingebracht sein, welche beispielsweise eine Exzitonenblockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss. Diese Schichten können ebenfalls unter Verwendung der erfindungsgemäßen Formulierungen, wie oben definiert, enthalten werden.

Bevorzugt kann vorgesehen sind, dass eine oder mehrere Schichten einer erfindungsgemäßen elektronischen Vorrichtung aus einer Gasphase, vorzugsweise durch Resublimation hergestellt werden. Demgemäß kann das vorliegende Granulat vorzugsweise so ausgestaltet werden, dass die entsprechende Beschichtungsvorrichtung mit dem

Granulat beschickt werden kann.

Insbesondere kann vorgesehen sein, dass das Granulat in eine Verdampfungsvorrichtung überführt wird.

Ferner kann vorgesehen sind, dass eine oder mehrere Schichten einer erfindungsgemäßen elektronischen Vorrichtung aus Lösung, wie z.B. durch Spincoating, oder mit einem beliebigen Druckverfahren, wie z.B. Siebdruck, Flexodruck oder Offsetdruck, besonders bevorzugt aber **LITI** (Light Induced Thermal Imaging, Thermotransferdruck) oder Ink-Jet Druck (Tintenstrahldruck), hergestellt werden.

Die Vorrichtung wird in an sich bekannter Weise je nach Anwendung entsprechend strukturiert, kontaktiert und schließlich hermetisch versiegelt, da sich die Lebensdauer derartiger Vorrichtungen bei Anwesenheit von Wasser und/oder Luft drastisch verkürzt.

Die erfindungsgemäßen Granulate, die hieraus erhältlichen elektronischen Vorrichtungen, insbesondere organische Elektrolumineszenzvorrichtungen, zeichnen sich durch einen oder mehrere der folgenden überraschenden Vorteile gegenüber dem Stand der Technik aus:

1. Die erfindungsgemäßen Granulate zeichnen sich durch eine hohe Umweltfreundlichkeit aus, wobei insbesondere die Arbeitsplatzsicherheit hoch ist.

2. Die Granulate der vorliegenden Erfindung können kostengünstig hergestellt werden.

3. Die erfindungsgemäßen Granulate ermöglichen einen sicheren und zuverlässigen Transport von Zusammensetzungen, die auch zur Herstellung von sehr feinstrukturierten elektronischen Vorrichtungen verwendet werden können.

4. Die erfindungsgemäßen Granulate können mit konventionellen Apparaten verarbeitet werden, so dass auch hierdurch Kostenvorteile erzielt werden können.

5. Die mit den erfindungsgemäßen Granulaten erhältlichen elektronischen Vorrichtungen zeigen eine sehr hohe Stabilität und eine sehr hohe Lebensdauer und eine ausgezeichnete Qualität im Vergleich zu elektronischen Vorrichtungen, die mit konventionellen Feststoffen erhalten werden, wobei die Eigenschaften auch nach einer längeren Lagerungs- oder Transportzeit der Materialien erzielt werden können.

Diese oben genannten Vorteile gehen nicht mit einer Verschlechterung der weiteren elektronischen Eigenschaften einher.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbarte Merkmal, sofern nichts anderes gesagt wird, als Beispiel einer generischen Reihe oder als äquivalentes oder ähnliches Merkmal zu betrachten.

Alle Merkmale der vorliegenden Erfindung können in jeder Art miteinander kombiniert werden, es sei denn, dass sich bestimmte Merkmale und/oder Schritte gegenseitig ausschließen. Dies gilt insbesondere für bevorzugte Merkmale der vorliegenden Erfindung. Gleichermaßen können Merkmale nicht wesentlicher Kombinationen separat verwendet werden (und nicht in Kombination).

Es sei ferner darauf hingewiesen, dass viele der Merkmale, und insbesondere die der bevorzugten Ausführungsformen der vorliegenden Erfindung selbst erfinderisch und nicht lediglich als Teil der Ausführungsformen der vorliegenden Erfindung zu betrachten sind.

Die mit der vorliegenden Erfindung offengelegte Lehre zum technischen Handeln kann abstrahiert und mit anderen Beispielen kombiniert werden. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

Nachfolgend wird anhand einer schematischen Zeichnung die Durchführung eines erfindungsgemäßen Verfahrens mit einer Anlage veranschaulicht.

Figuren:

Figur 1 zeigt in schematischer Darstellung eine Anlage zur Durchführung (1) eines erfindungsgemäßen Verfahrens. In der Anlage (1) wird eine Schmelze eines funktionalen Materials durch eine Einheit (10), auch Aufgabegefäß

genannt, zur Bereitstellung einer Schmelze zur Verfügung gestellt. Diese Einheit ist vorzugsweise als Anlage zur Herstellung eines funktionalen Materials ausgeführt. Die Schmelze wird aus der Einheit (10) über eine Düse (14) in ein Fallrohr (16) geleitet. In dem Fallrohr (16) wird die Schmelze zu einem Granulat abgekühlt, welches dem Fallrohr entnommen werden kann. Optional können weitere Komponenten in dem Aufbau der Anlage auftreten, beispielsweise kann zwischen Einheit (10) und Düse (14) eine Leitung (12) vorgesehen sein. Ferner kann aus dem Fallrohr (16) eine Leitung (18) zum Abführen des Granulats vorhanden sein. Die Anlage enthält vorzugsweise auch ein Auffanggefäß (19), das auch direkt an das Fallrohr angeschlossen sein kann, ohne, dass eine Leitung (18) vorhanden ist.

Figur 2 zeigt das funktionale Material M-1 hergestellt nach dem erfindungsgemäßen Verfahren. Der durchschnittliche Durchmesser der Granulatkörner beträgt 0,94 mm.

Dem Fachmann ist offensichtlich, dass zur Durchführung vieler der zuvor beschriebenen Ausführungsformen weitere Aggregate notwendig sind, die vorliegend nicht explizit bei der Beschreibung der Anlage dargelegt sind. Hierzu gehören insbesondere Pumpen sowie Kühlaggregate und Zu- oder Ableitungen für die zuvor beschriebenen Inertgase. Ferner ist festzuhalten, dass das Fallrohr mit Aggregaten oder konstruktiven Merkmalen so ausgestaltet werden kann, dass gebildete Aggregate besonders leicht und zweckmäßig entnommen werden können.

**Beispiele**

M-1 wurden im Aufgabegefäß (10) bei 290°C und 500 mbar aufgeschmolzen. Die Schmelze läuft über eine Düse (14) in das Fallrohr (16). Die Düse (14) hat einen Durchmesser von 0,3 mm. Das 2,5 m lange Fallrohr (16) ist mit einem Druck von 335 mbar Helium geflutet. Dass Fallrohr (16) ist auf einer Länge von 1,0 m mit einem Kühlmantel ausgestattet, welches mit flüssigem Stickstoff gekühlt ist. Das Granulat wird in einem Auffanggefäß (19) aufgefangen.

Einschränkung in der Skalierung sind bei kontinuierlicher Prozessführung nicht gegeben. Im diskontinuierlichen Betrieb sind die verarbeitbaren Mengen durch das Volumen des Aufgabegefäßes (10) und des Auffanggefäßes (19) vorgegeben. Beispiel 5 ist nicht Teil der vorliegenden Erfindung.

| Bsp. | Material | Aufgabegefäß | | Düse | Fallrohr | | | |
|---|---|---|---|---|---|---|---|---|
| | | T [°C] | p [mbar] | d [mm] | $l_{Gesamt}$ [m] | $l_{Kühl}$ [m] | T [°C] | p [mbar] |
| 1 | M-1 | 290 | 500 | 0,3 | 2,5 | 1,0 | -196 | 335 |
| 2 | M-1 | 290 | 500 | 0,3 | 4,0 | 2,5 | -80 | 335 |
| 3 | M-2 | 280 | 500 | 0,3 | 2,5 | 1,0 | -196 | 335 |
| 4 | M-3 | 275 | 500 | 0,3 | 2,5 | 1,0 | -196 | 335 |
| 5 | M-4 | 60 | 700 | 0,21 | 8 | 6,5 | -196 | 600 |

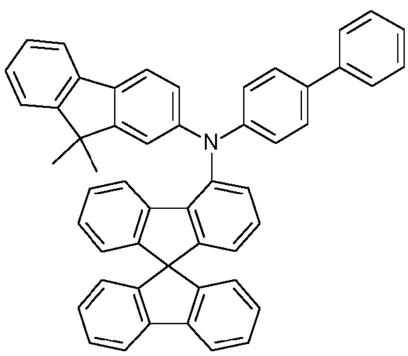

M-1 (WO 2013/120577)

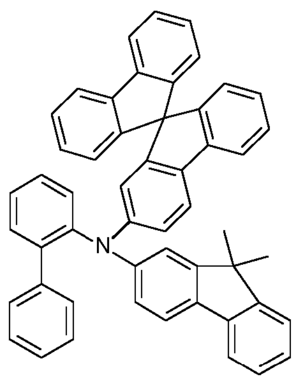

M-2 (WO 2012/034627)

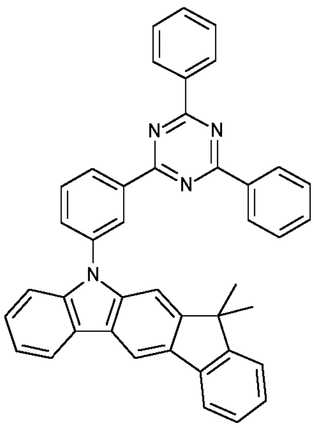

M-3 (WO 2010/136109)

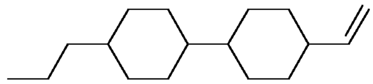

M-4 (WO 88/02357)

Figur 1 zeigt den Aufbau einer Anlage zur Herstellung des Granulats. Figur 2 zeigt ein Granulat enthaltend das funktionale Material M-1 hergestellt nach dem erfindungsgemäßen Verfahren. Der durchschnittliche Durchmesser der Granulatkörner beträgt 0,94 mm. Es ist deutlich zu erkennen, dass das Granulat wenig Feinanteil und wenig Staub enthält.

**Patentansprüche**

1. Verfahren zur Herstellung von Granulat, enthaltend mindestens ein funktionales Material (FM), welches zur Herstellung von Funktionsschichten elektronischer Vorrichtungen einsetzbar ist, umfassend die Schritte:

   A) Bereitstellung einer Schmelze eines funktionalen Materials, welches zur Herstellung von Funktionsschichten elektronischer Vorrichtungen einsetzbar ist, in einem Aufgabegefäß;
   B) Überführen der unter A) erhaltenen Schmelze in ein Fallrohr;
   C) Abkühlen der in das Fallrohr gemäß Schritt B) überführten Schmelze unter Erhalt eines Granulats,

   **dadurch gekennzeichnet, dass** der Druck bei dem die Schmelze in ein Fallrohr gemäß Schritt B) überführt wird, höher ist als der Druck im Fallrohr, wobei der Druck im Aufgabegefäß im Bereich von 400 bis 700 mbar liegt und der absolute Druck im Fallrohr im Bereich von 250 bis 500 mbar liegt, dass die in das Fallrohr gemäß Schritt B) überführte Schmelze in Schritt C) mit einem Inertgas abgekühlt wird und dass das gemäß Schritt C) erhaltene Granulat einen Feinanteil, der durch Partikel mit einem Durchmesser kleiner als 0,1 mm gebildet wird, kleiner 0,1 Gew.-% aufweist.

2. Verfahren gemäß Anspruch 1, wobei das
   funktionale Material (FM), welches zur Herstellung von Funktionsschichten elektronischer Vorrichtungen einsetzbar ist, ausgewählt ist aus der Gruppe bestehend aus fluoreszierenden Emittern, phosphoreszierenden Emittern, Emittern, die TADF (thermally activated delayed fluorescence) zeigen, Hostmaterialien, Elektronentransportmaterialien, Excitonenblockiermaterialien, Elektroneninjektionsmaterialien, Lochleitermaterialien, Lochinjektionsmaterialien, n-Dotanden, p-Dotanden, Wide-Band-Gap-Materialien, Elektronenblockiermaterialien, Lochblockiermaterialien und/oder Materialien, die Flüssigkristalline Eigenschaften besitzen.

3. Verfahren gemäß Anspruch 1 oder 2, wobei das funktionale Material (FM), welches zur Herstellung von Funktionsschichten elektronischer Vorrichtungen einsetzbar ist, zersetzungsfrei oberhalb einer Temperatur von 50°C schmelzbar ist.

4. Verfahren nach Anspruch 3, wobei das funktionale Material (FM), welches zur Herstellung von Funktionsschichten elektronischer Vorrichtungen einsetzbar ist, im geschmolzenen Zustand bei Verarbeitungstemperatur einen Abbau von höchstens 0,1 Gew.-% über eine Lagerdauer von 10 Stunden zeigt.

5. Verfahren nach Anspruch 1, wobei das Inertgas eine Temperatur von höchstens 0°C, aufweist bevorzugt im Bereich von -200 bis -70°C liegt.

6. Verfahren nach einem der vorhergehenden Ansprüche, wobei die in das Fallrohr gemäß Schritt B) überführte

Schmelze in Schritt C) über eine Fallhöhe von mindestens 50 cm gekühlt wird, vorzugsweise über eine Fallhöhe im Bereich von 100 bis 800 cm.

**7.** Verfahren nach einem der vorhergehenden Ansprüche, wobei die Schmelze in Schritt B) durch eine Düse in das Fallrohr überführt wird.

**8.** Verfahren nach Anspruch 7, wobei die Düse einen Durchmesser von höchstens 0,7 mm, vorzugsweise einen Durchmesser im Bereich von 0,1 bis 0,5 mm, besonders bevorzugt einen Durchmesser im Bereich von 0,2 bis 0,3 mm aufweist.

**9.** Verfahren nach einem der vorhergehenden Ansprüche, wobei das funktionale Material (FM), welches zur Herstellung von Funktionsschichten elektronischer Vorrichtungen einsetzbar ist, ausgewählt ist aus der Gruppe bestehend aus der Gruppe der Phenyle, Fluorene, Indenofluorene, Spirobifluorene, Carbazole, Indenocarbazole, Indolocarbazole, Spirocarbazole, Pyrimidine, Triazine, Lactame, Triarylamine, Dibenzofurane, Dibenzothiene, Imidazole, Benzimidazole, Benzoxazole, Benzthiazole, 5-Aryl-Phenanthridin-6-one, 9,10-Dehydrophenanthrene, Fluoranthene, Anthracene, Benzanthracene, Fluoradene.

**10.** Granulat erhältlich gemäß einem Verfahren der Ansprüche 1 bis 9, wobei das Granulat einen Feinanteil, der durch Partikel mit einem Durchmesser kleiner als 0,1 mm gebildet wird, kleiner 0,1 Gew.-% aufweist.

**11.** Verwendung eines Granulats gemäß Anspruch 10 zur Herstellung einer elektronischen Vorrichtung.

**12.** Verwendung gemäß Anspruch 11, wobei das Granulat in eine Verdampfervorrichtung überführt wird.

## Claims

**1.** Process for the preparation of a granular material comprising at least one functional material (FM) which can be employed for the production of functional layers of electronic devices, comprising the steps of:

A) provision of a melt of a functional material which can be employed for the production of functional layers of electronic devices, in a feed vessel;
B) transfer of the melt obtained under A) into a drop tube;
C) cooling of the melt transferred into the drop tube in step B) to give a granular material,

**characterised in that** the pressure at which the melt is transferred into a drop tube in step B) is higher than the pressure in the drop tube, where the pressure in the feed vessel is in the range from 400 to 700 mbar and the absolute pressure in the drop tube is in the range from 250 to 500 mbar, **in that** the melt transferred into the drop tube in step B) is cooled in step C) using an inert gas, and **in that** the granular material obtained in step C) has a fines content, formed by particles having a diameter of less than 0.1 mm, of less than 0.1% by weight.

**2.** Process according to Claim 1, where the functional material (FM) which can be employed for the production of functional layers of electronic devices is selected from the group consisting of fluorescent emitters, phosphorescent emitters, emitters which exhibit TADF (thermally activated delayed fluorescence), host materials, electron-transport materials, exciton-blocking materials, electron-injection materials, holeconduction materials, hole-injection materials, n-dopants, p-dopants, wide band gap materials, electron-blocking materials, hole-blocking materials and/or materials which have liquid-crystalline properties.

**3.** Process according to Claim 1 or 2, where the functional material (FM) which can be employed for the production of functional layers of electronic devices can be melted without decomposition above a temperature of 50°C.

**4.** Process according to Claim 3, where the functional material (FM) which can be employed for the production of functional layers of electronic devices exhibits a degradation of at most 0.1% by weight over a storage duration of 10 hours in the molten state at the processing temperature.

**5.** Process according to Claim 1, where the inert gas has a temperature of at most 0°C, preferably in the range from -200 to -70°C.

**6.** Process according to one of the preceding claims, where the melt transferred into the drop tube in step B) is cooled in step C) over a drop height of at least 50 cm, preferably over a drop height in the range from 100 to 800 cm.

**7.** Process according to one of the preceding claims, where the melt is transferred into the drop tube in step B) through a nozzle.

**8.** Process according to Claim 7, where the nozzle has a diameter of at most 0.7 mm, preferably a diameter in the range from 0.1 to 0.5 mm, particularly preferably a diameter in the range from 0.2 to 0.3 mm.

**9.** Process according to one of the preceding claims, where the functional material (FM) which can be employed for the production of functional layers of electronic devices is selected from the group consisting of the group of the phenyls, fluorenes, indenofluorenes, spirobifluorenes, carbazoles, indenocarbazoles, indolocarbazoles, spirocarbazoles, pyrimidines, triazines, lactams, triarylamines, dibenzofurans, dibenzothienes, imidazoles, benzimidazoles, benzoxazoles, benzothiazoles, 5-aryl-phenanthridin-6-ones, 9,10-dehydrophenanthrenes, fluoranthenes, anthracenes, benzanthracenes, fluoradenes.

**10.** Granular material obtainable by a process of Claims 1 to 9, where the granular material has a fines content, formed by particles having a diameter of less than 0.1 mm, of less than 0.1% by weight.

**11.** Use of a granular material according to Claim 10 for the production of an electronic device.

**12.** Use according to Claim 11, where the granular material is transferred into an evaporator device.

## Revendications

**1.** Procédé de préparation d'un matériau granulaire comprenant au moins un matériau fonctionnel (FM) pouvant être utilisé pour la production de couches fonctionnelles de dispositifs électroniques, comprenant les étapes :

A) de mise à disposition d'une masse fondue d'un matériau fonctionnel pouvant être utilisé pour la production de couches fonctionnelles de dispositifs électroniques, dans un récipient d'alimentation ;
B) de transfert de la masse fondue obtenue en A) dans un tube de descente ;
C) de refroidissement de la masse fondue transférée dans le tube de descente à l'étape B) afin d'obtenir un matériau granulaire,

**caractérisé en ce que** la pression à laquelle la masse fondue est transférée dans un tube de descente à l'étape B) est supérieure à la pression dans le tube de descente, la pression dans le récipient d'alimentation se trouvant dans la plage allant de 400 à 700 mbar et la pression absolue dans le tube de descente se trouvant dans la plage allant de 250 à 500 mbar, **en ce que** la masse fondue transférée dans le tube de descente à l'étape B) est refroidie à l'étape C) à l'aide d'un gaz inerte, et **en ce que** le matériau granulaire obtenu à l'étape C) présente une teneur en fines, formées par des particules ayant un diamètre inférieur à 0,1 mm, inférieure à 0,1% en poids.

**2.** Procédé selon la revendication 1, dans lequel le matériau fonctionnel (FM) pouvant être utilisé pour la production de couches fonctionnelles de dispositifs électroniques est choisi dans le groupe constitué par les émetteurs fluorescents, les émetteurs phosphorescents, les émetteurs présentant une TADF (fluorescence retardée activée thermiquement), les matériaux hôtes, les matériaux de transport d'électrons, les matériaux de blocage d'excitons, les matériaux d'injection d'électrons, les matériaux conducteurs de trous, les matériaux d'injection de trous, les dopants de type N, les dopants de type P, les matériaux à large bande interdite, les matériaux de blocage d'électrons, les matériaux de blocage de trous et/ou les matériaux présentant des propriétés de cristaux liquides.

**3.** Procédé selon la revendication 1 ou 2, dans lequel le matériau fonctionnel (FM) pouvant être utilisé pour la production de couches fonctionnelles de dispositifs électroniques peut être fondu sans décomposition au-dessus d'une température de 50°C.

**4.** Procédé selon la revendication 3, dans lequel le matériau fonctionnel (FM) pouvant être utilisé pour la production de couches fonctionnelles de dispositifs électroniques présente une dégradation d'au plus 0,1% en poids pendant une durée de stockage de 10 heures à l'état fondu à la température de traitement.

5. Procédé selon la revendication 1, dans lequel le gaz inerte présente une température d'au plus 0°C, préférablement dans la plage allant de -200 à -70°C.

6. Procédé selon l'une des revendications précédentes, dans lequel la masse fondue transférée dans le tube de descente à l'étape B) est refroidie à l'étape C) sur une hauteur de chute d'au moins 50 cm, préférablement sur une hauteur de chute dans la plage allant de 100 à 800 cm.

7. Procédé selon l'une des revendications précédentes, dans lequel la masse fondue est transférée dans le tube de descente à l'étape B) à travers une buse.

8. Procédé selon la revendication 7, dans lequel la buse présente un diamètre d'au plus 0,7 mm, préférablement un diamètre dans la plage allant de 0,1 à 0,5 mm, particulièrement préférablement un diamètre dans la plage allant de 0,2 à 0,3 mm.

9. Procédé selon l'une des revendications précédentes, dans lequel le matériau fonctionnel (FM) pouvant être utilisé pour la production de couches fonctionnelles de dispositifs électroniques est choisi dans le groupe constitué par les phényles, fluorènes, indénofluorènes, spirobifluorènes, carbazoles, indénocarbazoles, indolocarbazoles, spirocarbazoles, pyrimidines, triazines, lactames, triarylamines, dibenzofuranes, dibenzothiènes, imidazoles, benzimidazoles, benzoxazoles, benzothiazoles, 5-arylphénanthridin-6-ones, 9,10-déhydrophénanthrènes, fluoranthènes, anthracènes, benzanthracènes, fluoradènes.

10. Matériau granulaire pouvant être obtenu par un procédé selon les revendications 1 à 9, le matériau granulaire présentant une teneur en fines, formées par des particules ayant un diamètre inférieur à 0,1 mm, inférieure à 0,1% en poids.

11. Utilisation d'un matériau granulaire selon la revendication 10, pour la production d'un dispositif électronique.

12. Utilisation selon la revendication 11, dans laquelle le matériau granulaire est transféré dans un dispositif d'évaporation.

Figur 1

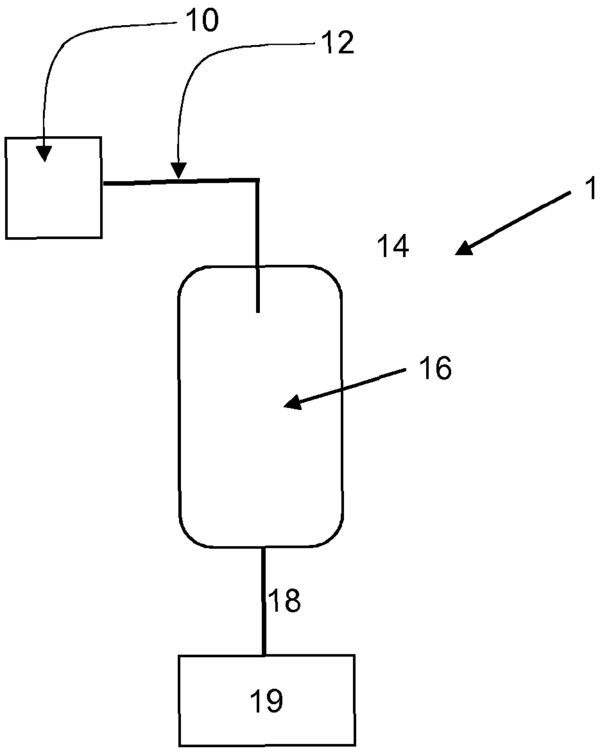


Figur 2

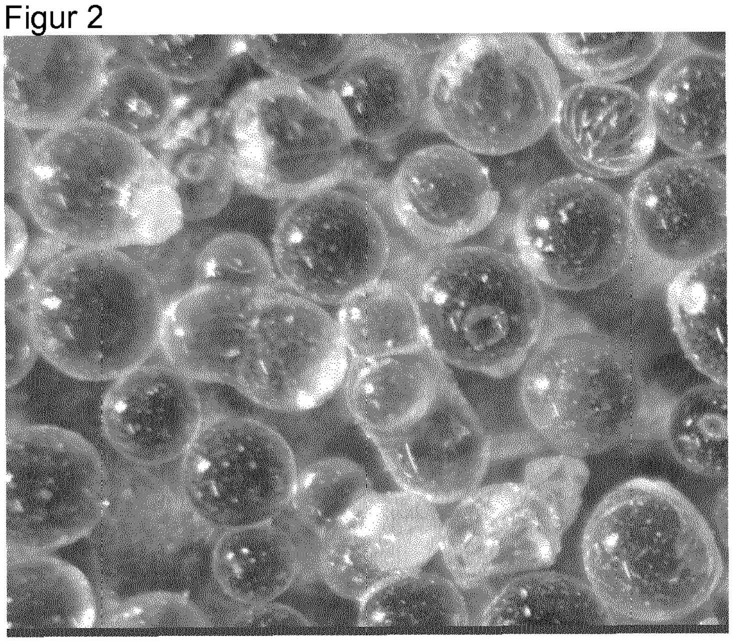

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 4400191 A
- DE 1767615 A1
- EP 2014355 A1
- DE 236477 C
- US 2008268245 A1
- WO 2011070963 A
- WO 2012133188 A
- WO 2015022974 A
- WO 2015098975 A
- US 3615404 A
- US 3567450 A
- US 3526501 A
- JP 56046234 A
- EP 1009041 A
- US 3615402 A
- JP 54110837 A
- US 3717462 A
- JP 61210363 A
- US 4950950 A
- JP 2204996 A
- JP 2282263 A
- JP 211399 A
- JP 632956965 A
- US 4720432 A
- US 4127412 A
- JP 193191 A
- US 3180730 A
- US 3658520 A
- US 20080102311 A1
- US 5061569 A
- JP 4308688 A
- US 20070092755 A1
- EP 1162193 B1
- EP 650955 B1
- DE 19646119 A1
- WO 2006122630 A1
- EP 1860097 A1
- EP 1834945 A1
- JP 08053397 A
- US 6251531 B1
- US 20050221124 A
- JP 08292586 A
- US 7399537 B2
- US 20060061265 A1
- EP 1661888 A
- WO 2009041635 A
- EP 0891121 A1
- EP 1029909 A1
- US 20040174116 A1
- US 5529853 A
- US 4356429 A
- US 4539507 A
- US 20070273272 A1
- US 5766779 A
- DE 102008064200
- JP 2003115387 A
- JP 2004311184 A
- JP 2001267080 A
- WO 2002043449 A
- EP 1480280 A
- EP 1478032 A
- EP 1469533 A
- US 20070087219 A1
- JP 2004200162 A
- US 20070252517 A1
- US 20070122656 A1
- US 20080193796 A1
- US 2006147747 A
- EP 1551206 A1
- WO 02068435 A1
- WO 02081488 A1
- EP 1239526 A2
- WO 04026886 A2
- WO 06122630 A
- WO 2008006449 A
- WO 2007140847 A
- WO 06000388 A
- WO 06058737 A
- WO 06000389 A
- WO 07065549 A
- WO 07115610 A
- US 5121029 A
- US 7250532 B2
- DE 102005058557 A1
- CN 1583691 A
- JP 8053397 A
- EP 1957606 A1
- US 20080113101 A1
- US 2006210830 A
- WO 08006449 A
- DE 102008035413
- DE 102009005746
- US 4769292 A
- US 6020078 A
- US 20060222886 A1
- US 5130603 A
- US 20070092753 A1
- WO 2014111269 A

- WO 0070655 A
- WO 0141512 A
- WO 0202714 A
- WO 0215645 A
- EP 1191613 A
- EP 1191612 A
- EP 1191614 A
- WO 05033244 A
- US 20090061681 A1
- US 20010053462 A1
- WO 2016124304 A
- US 6824895 B
- US 10729238 B
- US 6835469 B
- US 6830828 B
- US 7378162 B2
- US 6835469 B2
- JP 2003253145 A
- US 7238437 B2
- US 2009008607 A1
- EP 1348711 A
- WO 2011076314 A1
- EP 676461 A
- WO 09069566 A
- WO 04081017 A
- WO 2004058911 A
- WO 2005084081 A
- WO 2005084082 A
- WO 06048268 A
- WO 2006117052 A
- WO 2008145239 A
- US 20030027016 A1
- US 7326371 B2
- US 2006043858 A
- WO 2007114358 A
- WO 08145239 A
- JP 3148176 B
- EP 1009044 A
- US 2004018383 A
- WO 2005061656 A1
- EP 0681019 B1
- WO 2004013073 A1
- US 5077142 A
- WO 2007065678 A
- WO 05039246 A
- US 20050069729 A
- JP 2004288381 A
- EP 1205527 A
- WO 08086851 A
- EP 1617710 A
- EP 1617711 A
- EP 1731584 A
- JP 2005347160 A
- WO 04093207 A
- DE 102008033943
- WO 05003253 A
- WO 07137725 A
- WO 05111172 A
- DE 102008017591
- WO 06117052 A
- DE 102008036982
- WO 07063754 A
- WO 08056746 A
- DE 102009023155
- DE 102009031021
- DE 102009022858
- US 20070134514 A1
- US 20070128467 A1
- US 20050249976 A1
- US 20040209115 A
- US 20040209116 A
- EP 652273 B1
- WO 2007063754 A
- WO 2008056746 A
- WO 2010108579 A
- WO 04070772 A2
- WO 04113468 A1
- WO 05040302 A1
- WO 2005086251 A2
- WO 2012175535 A1
- WO 2012175219 A1
- WO 2012168358 A1
- WO 2012031735 A1
- EP 1837926 A1
- WO 2007107306 A1
- EP 2452946 A1
- EP 2463927 A1
- WO 2009000237 A1
- US 2007145355 A1
- US 7294849 B
- US 20030068528 A
- US 20030175553 A1
- WO 0070655 A2
- WO 0193642 A1
- US 20030175553 A

**In der Beschreibung aufgeführte Nicht-Patentliteratur**

- **YE TAO et al.** *Adv. Mater.*, 2014, vol. 26, 7931-7958
- **M. Y. WONG et al.** *Adv. Mater.*, 2017, vol. 29, 1605444
- *Synth.Metals*, 1997, vol. 91 (1-3), 209
- **Y.A. LEVIN ; M.S. SKOROBOGATOVA**. *Khimiya Geterotsiklicheskikh Soedinenii*, 1967 (2), 339-341
- **C.H.CHEN et al.** Recent developments in organic electroluminescent materials. *Macromol. Symp.*, 1997, vol. 125, 1-48

- Recent progress of molecular organic electroluminescent materials and devices. *Mat. Sci. and Eng. R*, 2002, vol. 39, 143-222
- **BALDO, THOMPSON et al.** *Nature*, 2000, vol. 403, 750-753
- **ADACHI et al.** *Appl. Phys. Lett.*, 2001, vol. 78, 1622-1624
- **J.KIDO et al.** *Appl. Phys. Lett.*, 1994, vol. 65, 2124
- **KIDO et al.** *Chem. Lett.*, 1990, vol. 657
- **JOHNSON et al.** *JACS*, vol. 105, 1983
- **WRIGHTON**. *JACS*, 1974, vol. 96
- **MA et al.** *Synth. Metals*, 1998, vol. 94, 245
- *Inorg. Chem.*, 2001, vol. 40 (7), 1704-1711
- *JACS*, 2001, vol. 123 (18), 4304-4312
- **H. GILMAN** ; **E.A. ZUECH**. *Chemistry & Industry*, 1960, 120
- **T. MATSUMOTO** ; **T. NAKADA** ; **J. ENDO** ; **K. MORI** ; **N. KAWAMURA** ; **A. YOKOI** ; **J. KIDO**. *Multiphoton Organic EL Device Having Charge Generation Layer*